Europäisches Patentamt

European Patent Office

Office européen des brevets

(19)

(11) EP 0 511 095 B1

(12) FASCICULE DE BREVET EUROPEEN

(45) Date de publication et mention
de la délivrance du brevet:
20.03.1996 Bulletin 1996/12

(51) Int Cl.⁶: H03M 7/30, G06F 17/14,
H04N 7/30

(21) Numéro de dépôt: 92401139.8

(22) Date de dépôt: 22.04.1992

(54) **Procédé et dispositif de codage-décodage d'un signal numérique**

Verfahren und Vorrichtung zur Kodierung und Dekodierung eines numerischen Signals

Coding and decoding method and apparatus for a digital signal

(84) Etats contractants désignés:
DE GB IT NL

(30) Priorité: 24.04.1991 FR 9105064

(43) Date de publication de la demande:
28.10.1992 Bulletin 1992/44

(73) Titulaire: FRANCE TELECOM
F-75015 Paris (FR)

(72) Inventeurs:
• Duhamel, Pierre
F-92130 Issy les Moulineaux (FR)
• Mahieux, Yannick
F-22140 Begard (FR)

(74) Mandataire: Fréchède, Michel et al
Cabinet Plasseraud
84, rue d'Amsterdam
F-75009 Paris (FR)

(56) Documents cités:
• PROCEEDINGS OF THE SOUTHEASTCON 1989
- ENERGY AND INFORMATION
TECHNOLOGIES IN THE SOUTHEAST vol. 2,
1989, NEW YORK pages 866 - 870; D.
REYNOLDS ET AL.: 'Analysis/synthesis Image
Coding System Based on Time Domain
Aliasing Cancellation'
• SPEECH COMMUNICATION vol. 6, no. 4,
Décembre 1987, AMSTERDAM NL pages 299 -
308; A. JOHNSON ET AL.: 'Adaptative
Transform Coding Incorporating Time Domain
Aliasing Cancellation'
• PROCEEDINGS OF THE 12TH INTERNATIONAL
CONFERENCE ON ACOUSTICS, SPEECH, AND
SIGNAL PROCESSING, 6-9 AVRIL 1987,
DALLAS vol. 4, 1987, NEW YORK pages 2161 -
2164; J. PRINCEN ET AL.: 'Subband/Transform
Coding Using Filter Bank Designs Based on
Time Domain Aliasing Cancellation'
• IEEE TRANSACTIONS ON ACOUSTICS,
SPEECH, AND SIGNAL PROCESSING vol. 34,
no. 5, Octobre 1986, NEW YORK pages 1153 -
1161; J. PRINCEN ET AL.: 'Analysis/synthesis
Filter Bank Design Based on Time Domain
Aliasing Cancellation'
• IEEE TRANSACTIONS ON ACOUSTICS,
SPEECH AND SIGNAL PROCESSING vol. 34,
no. 2, Avril 1986, NEW YORK pages 285 - 295;
P. DUHAMEL: 'Implementation of "Split Radix"
FFT Algorithms for Complex, Real and
Real-Symmetric Data'
• IEEE TRANSACTIONS ON ACOUSTICS,
SPEECH AND SIGNAL PROCESSING vol. 38,
no. 9, Septembre 1990, NEW YORK pages 1504
- 1511; P. DUHAMEL: 'Algorithms Meeting the
Lower Bound on the Multiplicative Complexity
of Length 2n DFT's and Their Connection with
Practical Algorithms'

**Description**

L'invention concerne un procédé et un dispositif de codage-décodage d'un signal numérique en vue de la réduction de son débit de transmission ou de son volume de stockage.

Parmi les techniques de codage-décodage connues à ce jour, le codage par transformée fréquentielle est l'une des plus performantes. Dans ce type de codeurs, le signal numérique subit en premier lieu une transformation temps-fréquence et ce sont les coefficients de la transformée fréquentielle qui sont codés et transmis.

Pour une qualité identique des signaux transmis, le gain en débit de transmission est lié au choix de la transformation utilisée pour le codage, une transformation inverse étant effectuée au décodage. Ainsi, une transformée en cosinus discrète modifiée TCDM, basée sur la suppression de la distorsion dans le domaine temporel (Time Domain Aliasing Cancellation ou TDAC en vocable anglo-saxon), est particulièrement performante par rapport aux transformées classiques, telles la transformée de Fourier discrète TFD ou la transformée en cosinus discrète TCD. Pour une étude comparée des performances relatives de ces types de traitement, on pourra se reporter à l'article "Analysis/synthesis filter bank design based on Time Domain Aliasing Cancellation" publié par J.P. Princen et A.B. Bradley, IEEE Transactions on ASSP, vol 34, p 1153 - 1161 Octobre 1986.

Cette technique de traitement et de codage, lorsqu'elle est comparée aux techniques de codage par bancs de filtres, apparaît beaucoup plus robuste. En outre, si pour des taux de compression relativement faibles, par exemple pour un signal audio-numérique haute qualité dont le débit est ramené à 128 kbits/s au lieu de débit de valeur supérieure, la technique de codage précitée n'apparaît pas sensiblement meilleure, l'utilisation de celle-ci semble pratiquement inévitable pour des taux de compression beaucoup plus élevés. Mais dans un tel cas, de telles performances de compression se traduisent par une complexité accrue.

Pour que les algorithmes de codage utilisant la TCDM puissent fonctionner en temps réel, c'est-à-dire pour que les processeurs de codage dédiés correspondants puissent être mis en oeuvre dans des conditions de coût et de fiabilité de fonctionnement satisfaisantes, il est indispensable d'établir un procédé de codage et de calcul rapide de cette transformation, afin de faciliter de façon substantielle tant l'implantation et la mise en oeuvre que le fonctionnement en temps réel des processeurs précités.

Dans le procédé décrit par Princen et Bradley précédemment cité, les coefficients de transformée sont définis par :

$$(1) \quad y(m,k) = \sum_{n=0}^{N-1} xm(n).h(N-1-n).\cos(2\pi.(k+1/2)(n+N_O)/N)$$

avec k=0,..., N-1 Dans cette relation, N est la taille ou nombre d'échantillons x(n) du bloc de transformée, h(n) est la fenêtre de pondération des blocs obtenue par pondération spatiale ou temporelle, m est le numéro du bloc de transformation, xm(n) indique l'échantillon de signal, d'ordre n du bloc m considéré. Le déphasage $N_o$ est nécessaire à la reconstruction parfaite du signal d'origine.

Le nombre de coefficients indépendants y(m,k) dans le domaine fréquentiel est égal à N/2, en raison de la relation y(k-1) = -y(N-k). La transformée inverse $TCDM^{-1}$ nécessaire à la reconstruction ou synthèse du signal audio d'origine ne peut donc pas délivrer la séquence originale. L'échantillonnage, imparfait dans le domaine fréquentiel, se traduit par une distorsion ou "aliasing" dans le domaine temporel.

La synthèse peut cependant être exprimée à l'aide d'une transformée par blocs avec chevauchement des blocs consécutifs. Le signal synthétisé au bloc mo s'écrit, échantillon d'ordre n du signal audio reconstitué $x^r mo(n)$:

$$x^r mo(n) = f(n+N/2).Xmo - 1(n+N/2) + f(n).Xmo(n)$$

pour n = 0,...,N/2-1.

Dans la relation précédente, f(n) est la fenêtre de synthèse et Xmo(n) est la transformée inverse des coefficients de transformée y(mo,k), soit :

$$Xmo(n) = TCDM^{-1}y(mo,k),$$

soit :

$$(2) \quad Xm(n) = (1/N) \sum_{k=o}^{N-1} y(m,k).\cos(2\pi.(k+1/2)(n+N_O)/N)$$

La reconstruction parfaite du signal de départ soit : $x^r mo(n) = xmo(n)$ est obtenue en imposant les conditions sur les fenêtres d'analyse h(n) et de synthèse f(n), ainsi que sur le terme de déphasage No.

Ainsi, les termes de distorsion ou "aliasing" d'un bloc à l'autre sont de module identique et de signe contraire, et donc s'annulent, lorsque les fenêtres d'analyse h(n) et de synthèse f(n) sont identiques, de longueur égale, symétriques par rapport à N/2 et vérifient les relations :

$$(3) \qquad f(n+N/2).h(n) - f(n).h(N/2+n) = 0$$

$$(4) \qquad f^2(n+N/2) + f(n) = 2$$

pour n = 0,...,N/2-1.

$$(5) \qquad no = N/4+1/2$$

A titre d'exemple, les fenêtres d'analyse et de synthèse ci-après présentant un recouvrement de 50 % interblocs vérifient les conditions précédentes :

$$(6) \qquad h(n) = f(n) = \sqrt{2}.\sin(\pi.(n+1/2)/N)$$

pour n = 0,...,N-1.

L'avantage principal de la TCDM réside dans le fait de pouvoir utiliser les fenêtres précitées performantes dans le domaine fréquentiel, sans diminuer le débit disponible par coefficient à coder. La TCDM associée aux fenêtres précitées assure une séparation correcte des composantes du signal et donc une meilleure concentration de l'énergie. Cette amélioration de la représentation spectrale facilite en outre la prise en compte des phénomènes perceptuels, du fait de la forte réduction de l'étalement spectral, ce qui n'est pas le cas lors de l'emploi d'une fenêtre rectangulaire par exemple.

La TCDM définie précédemment selon la relation (1) peut être calculée au moyen d'une FFT (transformée de Fourier rapide) de même taille, la TCDM précitée pouvant s'écrire :

$$(7) \qquad y(m,k) = Re[e^{j2\pi(k+1/2)no/N} . \sum_{n=0}^{N-1} xm(n).h(N-1-n).e^{j2\pi(k+1/2)n}]$$

où Re[.] désigne la partie réelle de l'expression complexe entre crochets, soit :

$$(8) \qquad y(m,k) = Re [e^{j2\pi(k+1/2)no/N} .TFD (xm(n).h(N-1-n).e^{j\pi n/N})]$$

On notera cependant que l'application directe de la relation (8) précitée nécessite le nombre d'opérations de calcul ci-après :

- calcul de $x(n).e^{j\pi n/N}$, soit N produits réels et complexes,
- FFT de longueur N,
- calcul de la partie réelle du produit terme à terme de deux vecteurs complexes de longueur N.

Pour $N=2^p$ et pour un algorithme de calcul le plus efficace connu actuellement tel que décrit dans l'article "Implementation of split Radix FFT algorithms for complex, real and real symetric data" par Pierre Duhamel, IEEE on ASSP vol 34 pp 285-295 Avril 1986, alors le calcul de la relation (8) nécessite 2N+N.(p-3+4)+2N multiplications et 3N(p-1)+4+N additions, soit un total de N(4p-1)+8 opérations, sans tenir compte des opérations de pondération spatio-temporelles nécessaires au fenêtrage. Ces nombres élevés lorsque la taille des blocs de transformée est importante, N = 1024 par exemple en codage-décodage d'un signal audionumérique, peuvent pénaliser l'emploi de la TCDM dans un procédé de codage-décodage destiné à fonctionner en temps réel.

Le procédé et le dispositif de codage-décodage d'un signal numérique (x) représenté par des échantillons numériques x(n) objets de la présente invention ont pour but de remédier aux inconvénients précités.

Un autre objet de la présente invention est la mise en oeuvre d'un procédé et d'un dispositif de codage-décodage d'un signal numérique grâce auxquels le nombre d'opérations nécessaire au codage est sensiblement diminué.

Un autre objet de la présente invention est enfin la mise en oeuvre d'un procédé de codage-décodage d'un signal numérique, lequel, en raison de la simplification du processus de traitement, permet l'implantation d'un tel processus de traitement sur un processeur dédié, dans des conditions de coûts et de fiabilité compatibles avec un fonctionnement en temps réel.

Le procédé de codage d'un signal numérique (x) représenté par des échantillons numériques x(n), objet de la présente invention, est appliqué à des échantillons regroupés en blocs de N échantillons successifs.

Il est remarquable en ce que, suite à une opération de fenêtrage consistant à effectuer une pondération spatiale ou temporelle des échantillons fonction de l'ordre n, dans le bloc, de ces derniers, y(n) = x(n).h(N-1-n), où h(N-1-n) représente une loi de pondération déterminée, est effectuée une transformée en cosinus discrète modifiée, TCDM, au niveau des blocs d'échantillons, pour calculer les coefficients d'ordre pair de la transformation ci-après :

$$(9) \qquad Y2k = \sum_{n=0}^{N-1} yn.\cos(2\pi/(4N).(2n+1).(4k+1)+(4k+1).\pi/4)$$

pour

$$k \in [0,..., N/2-1] \qquad \text{avec } YN-k = -Yk-1,$$

le terme de déphasage étant réparti en fonction de l'ordre k du coefficient précité. Les coefficients de transformation d'ordre pair calculés, Y2k, sont exprimés sous forme d'une transformation complexe inversible :

$$(10) \quad Y2k+N/4+jY2k =$$

$$(-1)^{k+1}.W8^{-1}. \sum_{n=0}^{N/4-1} ((y'n-y''n+N/4)+j(y''n+y'n+N/4))$$

$$.W4N^{(4k+1)(4n+1)}$$

pour k = 0,..., N/4-1
avec

$$y'n = x2n.h2n$$
$$y''n = xN-2n-1.hN-2n-1$$
$$W4N = \cos(2\pi/4N) + j.\sin(2\pi/4N)$$
$$W8 = W4N \qquad \text{pour } N-2.$$

La transformation complexe inversible précitée est alors calculée à partir de l'expression de calcul auxiliaire

$$(11) \qquad Zk = (-1)^{k+1}.W8^{-1}.W4N^{4k+1}. \sum_{n=0}^{N/4-1} (zn.WN^{n}).WN/4^{nk}$$

où

$$(12) \qquad zn = (y2n-yN/2-1-2n) + j(yN-1-2n+yN/2+2n)$$

et

$$WN = \cos(2\pi/N) + j.\sin(2\pi/N).$$

Le dispositif de codage d'un signal numérique (x) représenté par des échantillons numériques x(n) regroupés en blocs de N échantillons successifs est remarquable en ce qu'il comprend une première et une deuxième mémoires d'entrée permettant chacune la mémorisation de N/2 échantillons successifs, la deuxième mémoire d'entrée permettant la mémorisation des échantillons retardés de N/2. Un circuit de calcul permet, suite à une opération de fenêtrage consistant à effectuer une pondération spatiale des échantillons yn = x(n).h(N-1-n) où h(N-1-n) représente une loi de pondération déterminée, sur lesdits échantillons, d'effectuer une transformée en cosinus discrète modifiée TCDM, de façon à calculer les coefficients de transformée d'ordre pair de la forme

$$Y2k = \sum_{n=0}^{N-1} yn.\cos((2\pi/4N).(2n+1).(4k+1)+(4k+1)\pi/4)$$

pour $k \in [0,..., N/2-1]$,
avec YN-k = -Yk-1, le terme de déphasage étant réparti en fonction de l'ordre k du coefficient considéré, à partir d'une transformation complexe inversible

$$Y2k+N/4+jY2k,$$

à partir d'une expression de calcul auxiliaire

$$Zk = (-1)^{k+1}.W8^{-1}.W4N^{4k+1}. \sum_{n=0}^{N/4-1} (zn.WN^{n}).WN/4^{nk}$$

où

$$zn = (y2n-yN/2-1-2n) + j(yN-1-2n+yN/2+2n)$$

pour n = 0,..., N/4-1.

Le procédé et le dispositif de décodage d'un signal numérique x représenté par des échantillons numériques x(n), ces échantillons étant regroupés en blocs de N échantillons et codés conformément au procédé de codage objet de l'invention, consiste à ou permet de, successivement, effectuer une permutation des parties réelles YN/4+2k et imaginaire Y2k des coefficients de transformation transmis, à soumettre les coefficients permutés à un processus de traitement de codage par calcul de la partie complexe de la TCDM directe, de la forme Re[Zk], Im[Zk], à permuter les parties réelles et imaginaires de la partie complexe, puis à effectuer un calcul de recouvrement pour restituer les échantillons x(n).

Le procédé et le dispositif objets de la présente invention trouvent application à la réduction de débit de transmission ou de volume de stockage de signaux audio ou vidéo numériques.

Une description plus détaillée en sera donnée ci-après à l'aide d'un exposé et de dessins dans lesquels

- la figure 1 représente un organigramme général de mise en oeuvre du procédé objet de l'invention, au niveau du codage,
- la figure 2 représente un organigramme d'un mode de réalisation particulièrement avantageux non limitatif des étapes essentielles du mode de réalisation de la figure 1,
- la figure 3 représente un organigramme d'un mode de réalisation du procédé objet de l'invention, au niveau décodage,
- la figure 4 représente un schéma synoptique d'un mode de réalisation, d'un dispositif de codage d'un signal numérique conforme à l'objet de la présente invention,
- la figure 5a représente un schéma synoptique d'un dispositif de décodage d'un signal numérique codé au moyen du dispositif de codage représenté en figure 4 conformément à l'objet de l'invention,
- la figure 5b représente un détail de réalisation de la figure 5a.
- la figure 6 représente un schéma synoptique d'un mode de réalisation d'un dispositif de codage ou de décodage, dans lequel les opérations de calcul relatives au fenêtrage ou au recouvrement spatio-temporel des échantillons sont intégrées au calcul d'un produit complexe, le coût en nombre d'opérations du fenêtrage ou du recouvrement étant ainsi supprimé.

Le procédé objet de l'invention sera tout d'abord décrit en ce qui concerne le codage d'un signai numérique x représenté par des échantillons numériques x(n).

Les échantillons sont regroupés en blocs de N échantillons successifs.

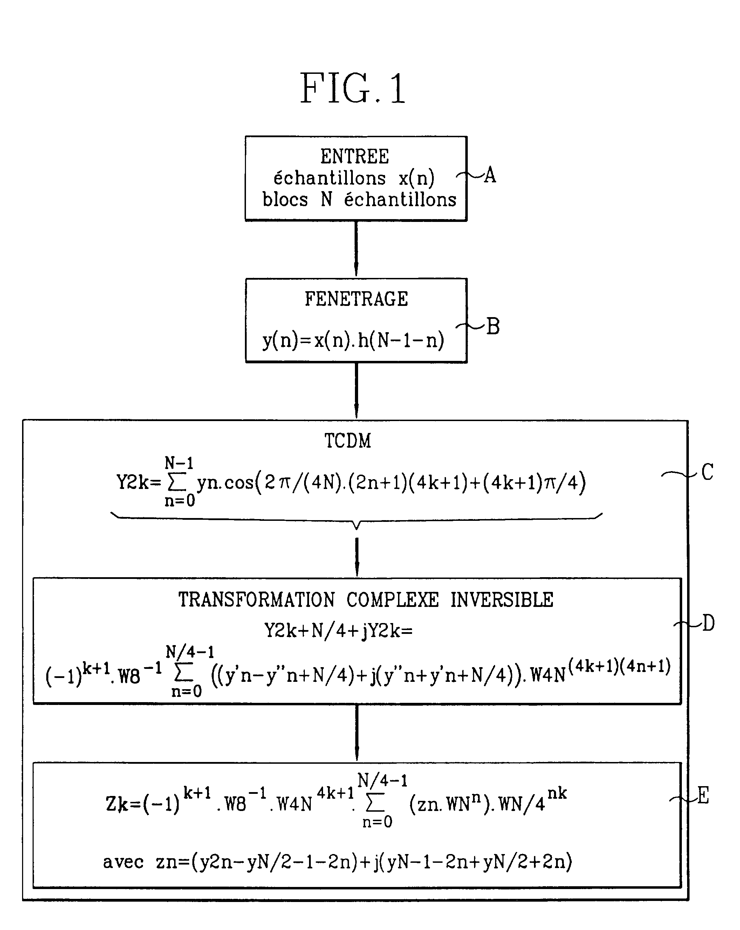

De manière classique, le procédé de codage objet de l'invention, ainsi que représenté en Figure 1, consiste tout d'abord à effectuer une opération de fenêtrage par pondération spatiale ou temporelle des échantillons, fonction de l'ordre des échantillons n dans le bloc considéré.

Sur la figure 1, on a représenté en premier lieu une étape, notée A, consistant, pour un bloc de N échantillons considéré en une opération d'entrée de ces échantillons, cette opération d'entrée correspondant sensiblement à une mémorisation dans des conditions particulières qui seront décrites ultérieurement dans la description de ces échantillons considérés.

L'étape A précitée est suivie d'une étape B consistant, en fait, en l'opération de fenêtrage précédemment mentionnée pour engendrer pour chaque échantillon x(n) un échantillon pondéré noté :

$$y_n = x(n).h(N-1-n).$$

Dans la relation précitée h(N-1-n) représente une loi de pondération déterminée. Bien entendu, cette loi de pondération satisfait aux conditions précédemment énoncées, cette loi de pondération pouvant être de la forme telle que donnée dans la relation (6) précédemment dans la description.

Le procédé de codage objet de la présente invention consiste alors, ainsi que représenté à l'opération C de la figure 1, à effectuer une transformée en cosinus discrète modifiée TCDM au niveau des blocs d'échantillons, essentiellement des échantillons pondérés obtenus à l'issue de l'étape B pour calculer les coefficients d'ordre pair de la transformation de la forme :

$$Y_{2k} = \sum_{n=0}^{N-1} y_n . \cos(2\pi/(4N).(2n+1)(4k+1)+(4k+1)\pi/4)$$

Selon un aspect avantageux du procédé objet de l'invention, la transformation d'ordre pair précitée est calculée pour :

$$k \in [0,...N/2-1].$$

Le calcul des termes pairs est seul nécessaire en raison de l'antisymétrie :

$$k \in [0,...,N/2-1] \qquad \text{avec } Y_{N-k} = -Y_{k-1}.$$

On notera que dans la relation (2) précitée, le terme de déphasage est réparti en fonction de l'ordre k du coefficient de transformation considéré.

Selon un aspect particulièrement avantageux du procédé de codage objet de la présente invention, les coefficients de transformation d'ordre pair précédemment cités sont exprimés sous forme d'une transformation complexe inversible à l'étape D de la figure 1.

Cette transformation complexe inversible vérifie la relation :

$$y2k+N/4+jY2k =$$
$$(-1)^{k+1}.W8^{-1}.\sum_{n=0}^{N/4-1}((y'n-y''n+N/4)+j(y''n+y'n+N/4))$$
$$.W4N^{(4k+1)(4n+1)}.$$

La relation précitée est calculée pour
k = 0,...,N/4-1.
Dans cette relation, on note la valeur des expressions ci-après :
$$y'n = x2n.h2n,$$
$$y''n = xN-2n-1.hN-2n-1,$$
$$W4N = \cos(2\pi/4N) + j.\sin(2\pi/4N).$$

On notera en particulier que l'expression W4N désigne la racine quatre-n.ième de l'unité.

Ainsi que représenté, en outre, en figure 1, la transformation complexe inversible précitée est calculée à partir de l'expression de calcul auxiliaire :

$$zk = (-1)^{k+1}.W8^{-1}.W4N^{4k+1}.\sum_{n=0}^{N/4-1}(zn.WN^n).WN/4^{nk}.$$

Dans la relation précitée, on désigne par zn l'expression
$$zn = (y2n-yN/2-1-2n) + j(yN-1-2n+yN/2+2n),$$
cette expression étant calculée également pour
n = 0,...,N/4-1.

D'une manière générale, on considère selon un aspect particulièrement avantageux, conformément au procédé de codage objet de la présente invention, que la transformation complexe inversible, telle qu'établie à l'étape D de la figure 1, peut alors être calculée très efficacement à l'étape suivante E à partir de la relation précitée.

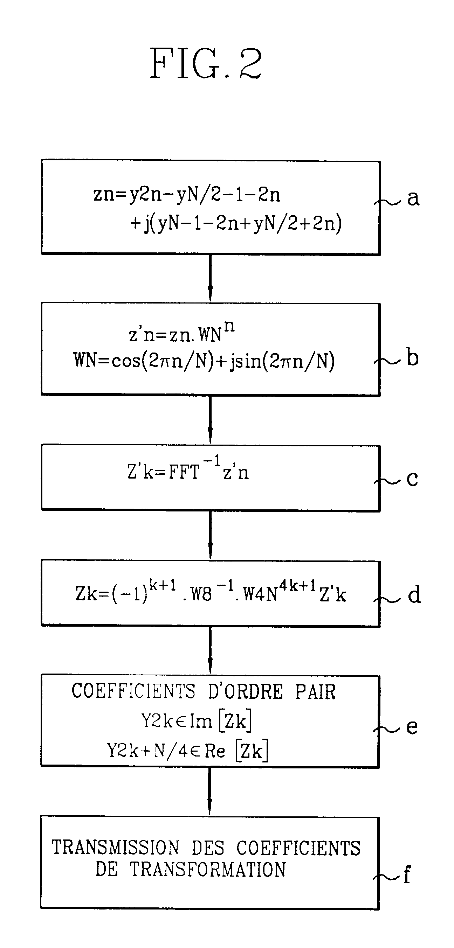

Un mode de réalisation particulièrement avantageux du processus de calcul, conformément aux étapes de calcul E et D précédemment décrites en relation avec la figure 1 sera maintenant décrit de manière plus détaillée en relation avec la figure 2.

Selon la figure précitée, le calcul de la transformation complexe inversible précédemment mentionné est effectué par les étapes successives suivantes :

-   étape a : calcul de zn selon relation (12),
    pour n = 0,...,N/4-1,
    soit un coût effectif de N/2 additions réelles,
-   étape b : calcul de

$$(13) \qquad z'n = zn.WN^n$$

   pour n = 0,...,N/4-1,
   cette étape nécessitant N/4-1 multiplications complexes, l'expression $WN^n$ vérifiant la relation :

$$WN^n = \cos(2\pi\frac{n}{N}) + j.\sin(2\pi\frac{n}{N}).$$

-   étape c : transformée de Fourier rapide inverse sur la variable z'n précédemment obtenue à l'étape b pour l'obtention de :

$$(14) \qquad Z'k = FFT^{-1}.z'n.$$

On notera que la transformée de Fourier rapide est une transformée de Fourier de taille N/4, une telle opération mettant en oeuvre des processus de traitement connus.

L'étape c est alors suivie d'une étape d, telle que représentée en figure 2, laquelle consiste en un calcul de

l'expression :

$$(15) \qquad Zk = ((-1)^{k+1}.W8^{-1}.W4N^{4k+1}.Z'k)$$

pour k = 0,...,N/4-1

Dans la relation précitée, on notera que W8 désigne la racine 8ème de l'unité, et $W4N^{4k+1}$ la racine quatre-énième de l'unité élevée à la puissance 4k+1.

Le calcul de l'expression précitée est effectué pour k = 0,...,N/4-1;

- étape e : détermination successive des coefficients de transformation d'ordre pair donnés par les relations

$$(16) \qquad Y2k \in Im[Zk] \text{ partie imaginaire de Zk,}$$
$$(17) \qquad Y2k+N/4 \in Re[Zk] \text{ partie réelle de Zk.}$$

On notera ainsi que les coefficients d'ordre pair sont donnés par la partie imaginaire et par la partie réelle de l'expression Zk précédemment mentionnée.

- étape f : de transmission en lieu et place des échantillons numériques x(n), constituant le signal numérique, des coefficients de transformation précédemment obtenus à l'étape e. Cette transmission est réalisée par transmission sous forme de signal codé.

On notera qu'une étape identique de détermination des coefficients de transformation d'ordre impair, les coefficients d'ordre pair ayant été déterminés, n'est pas nécessaire, ces coefficients étant donnés par la relation d'antisymétrie à partir des coefficients d'ordre pair :

$$(18) \qquad Y2K+1 = -Y2k,$$
$$(19) \qquad Y2k+1+N/4 = -Y2k+N/4.$$

Afin de réaliser l'étape c de calcul de la transformée de Fourier rapide, on préférera utiliser la méthode de calcul décrite par Pierre Duhamel dans la publication intitulée : "Implementation of Split-Radix FFT algorithms for complex real and real symetric data" précédemment cité dans l'introduction à la description.

Dans un tel cas, le nombre d'opérations de calcul nécessaires à la conduite du procédé de codage objet de la présente invention peut être évalué de la manière ci-après:

. nombre de multiplications total :

N/4(q+1), multiplications réelles, avec $N=2^q$,

. nombre d'additions :

N/4(3q-1), additions réelles.

Si l'on cumule le nombre d'opérations réelles, on constate que le nombre total minimum d'opérations requis pour la mise en oeuvre du procédé de codage objet de la présente invention est très exactement égal à N.q. Pour l'évaluation du nombre d'opérations précité, on a considéré, selon la pratique habituelle, en complexité de calcul, qu'une multiplication complexe est équivalente à 3 multiplications et à 3 additions réelles.

Une évaluation pour une équivalence avec 4 multiplications et 2 additions réelles peut être envisagée, mais aboutit alors à des expressions beaucoup plus complexes. Le nombre total d'opérations N.q reste cependant inchangé. Le procédé de codage objet de la présente invention permet donc une amélioration d'un facteur 4 par rapport au procédé de codage de l'art antérieur exposé dans l'introduction à la description de la présente demande de brevet.

On notera en particulier que le terme de complexité précédemment défini est compatible avec celui des meilleures méthodes de codage par FFT. En effet, les liens entre ce type de processus de codage FFT et relations (11) et (12) définissant l'expression Zk donnée à l'étape E du procédé de codage objet de la présente invention sont bi-latéraux et bi-univoques. Le même auteur Pierre Duhamel a démontré dans l'article "Algorithms meeting the lower bound on the multiplicative complexity of length 2n DFT's and their connection with practical algorithms" publié dans la revue IEEE trans on ASSP, volume 38, pages 1504, 1511 en Septembre 1990, que la partie active d'une transformée de Fourier rapide de type split radix correspondante de taille N était justement donnée par la relation précédemment mentionnée de taille N/16 et qu'en conséquence le calcul de cette partie active s'effectuait suivant le schéma expliqué précédemment, à l'exception peut-être de quantités constantes telles que $W8^{-1}$ et $(-1)^{k+1}$ par exemple.

Ainsi, le terme compatibilité doit-il être compris comme le fait que l'amélioration du processus de traitement par transformée de Fourier rapide de type split radix fournirait un meilleur processus de transformée en cosinus discrète modifiée TCDM, mais que l'amélioration du processus de transformée en cosinus discrète modifiée TCDM tel que celui proposé présentement, selon le procédé de codage objet de la présente invention, fournirait également un meilleur processus de traitement par transformée de Fourier rapide FFT que ceux connus actuellement.

En conséquence, le procédé objet de la présente invention est en terme de nombre d'opérations, c'est-à-dire de multiplications et d'additions réelles, le meilleur que l'on puisse proposer en l'état actuel des connaissances sur ce type de processus de traitement.

Dans le mode de réalisation du processus de codage tel que représenté en figure 2, il est possible de modifier les étapes b et d précédemment décrites en retirant de l'étape d la multiplication par $W8^{-1}$ et en l'incluant à l'étape b précédemment mentionnée. Une telle opération modifie les symétries des tables de sinus et de cosinus, tables de valeurs nécessaires pour la mise en oeuvre du procédé de codage objet de la présente invention.

Inclure la multiplication par $W8^{-1}$ au niveau de l'étape b modifie les symétries des tables mémoires correspondantes. On notera cependant que l'utilisation de ces tables peut être alors facilitée.

En outre, l'expression de calcul auxiliaire Zk étant exprimée sous la forme :

$$(12b) \quad Zk = (-1)^{k+1}.W8^{-1}.WN^{k}.\sum_{n=0}^{N/4-1}(zn.W4N^{(4n+1)}.WN/4^{nk})$$

les étapes b et d de la figure 2 peuvent alors être interverties. Les multiplications complexes par $W4N^{(4n+1)}$ sont alors placées en début ou en fin de calcul. Le choix est déterminé en fonction du temps de calcul minimum.

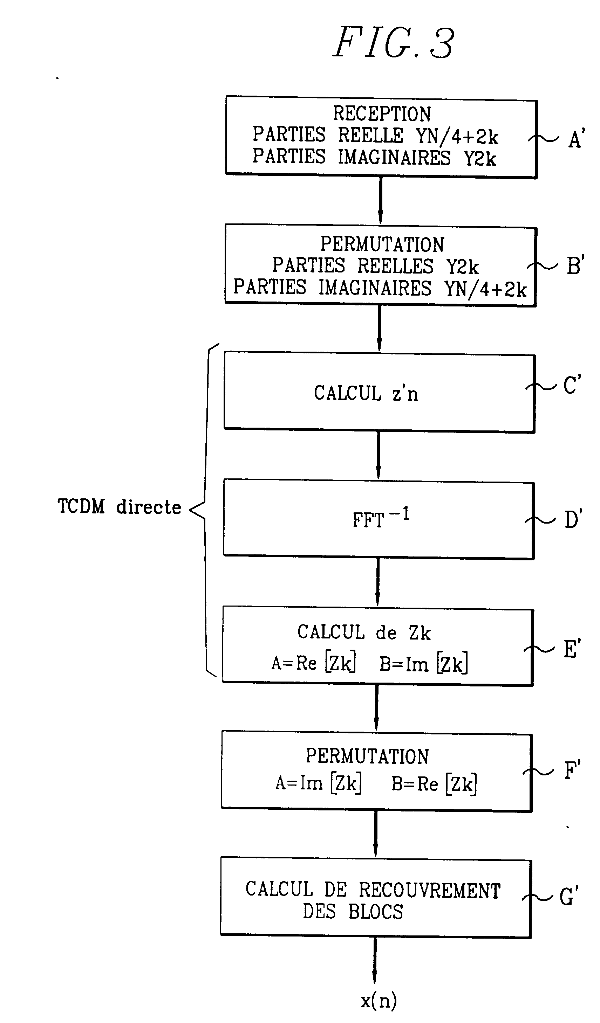

Un procédé de décodage d'un signal numérique x représenté par des échantillons numériques x(n) regroupés en blocs et codés selon le procédé de codage précédemment décrit sera maintenant décrit en liaison avec la figure 3.

Selon la figure précitée, suite à une étape A′ de réception des parties réelles YN/4+2k et partie imaginaire Y2k précédemment transmises, suite au codage selon le procédé de l'invention, le procédé de décodage consiste en une étape B′ à effectuer une permutation des parties réelles YN/4+2k et imaginaires Y2k des coefficients de transformation transmis.

Conformément à un aspect particulièrement avantageux du procédé de codage et de décodage objet de la présente invention, celui-ci consiste, en outre, au niveau du décodage, en une étape C', telle que représentée en figure 3, à soumettre les coefficients permutés précédemment mentionnés à un processus de traitement de codage par calcul de la partie complexe de la TCDM directe de la forme Re[Zk], Im[Zk].

L'opération consistant à soumettre les coefficients permutés à un processus de traitement de codage par calcul de la partie complexe de la TCDM directe est justifiée par le fait que l'ensemble des étapes b, c, d, décrit précédemment en relation avec la figure 2 forme une transformation complexe inversible. En conséquence, l'inverse de la transformée constituée par les étapes précitées constitue le noyau d'une transformée en cosinus discrète modifiée inverse, ou TCDM inverse, cette TCDM étant calculée au moyen d'une TCDM directe correspondante, suite à interversion des parties réelles et imaginaires des signaux d'entrée, une telle interversion ayant pour effet, pour tout signal d'entrée sous forme complexe z = a+jb, d'engendrer un signal complexe interverti de la forme z* = b+ja pour engendrer les signaux d'entrée inversés, puis calcul de la TCDM directe des signaux d'entrée inversés pour engendrer des signaux de sortie notés Y*k. On notera bien sur que l'interversion des parties réelles et imaginaires des signaux de sortie Y*k permet d'engendrer des signaux de sortie inverse Yk, ce qui revient à permuter les parties réelles et imaginaires de la partie complexe de la TCDM précitée.

Le procédé de décodage, objet de la présente invention, est alors suivi d'une étape G' de calcul de recouvrement des blocs pour restituer les échantillons x(n).

Dans le procédé de décodage, objet de la présente invention, le processus de traitement, identique au processus de traitement de codage, formé par les étapes C', D', E′ de la figure 3, effectuant un calcul de la partie complexe de la TCDM directe, comprend, de la même manière que dans le procédé de codage, mais sur les parties réelles et parties imaginaires permutées reçues après transmission, le calcul en C' de z'n = zn.$WN^{n}$ pour n = 0,...,N/4-1, calcul en D' par transformée de Fourier rapide inverse $FFT^{-1}$ de taille N/4 de Z'k = $FFT^{-1}$.z'n, puis calcul à l'étape E' de l'expression selon la relation :

$$(15) \quad Zk = ((-1)^{k+1}.W8^{-1}.W4N^{4k+1}).Z'k$$

pour k = 0,...,N/4-1.

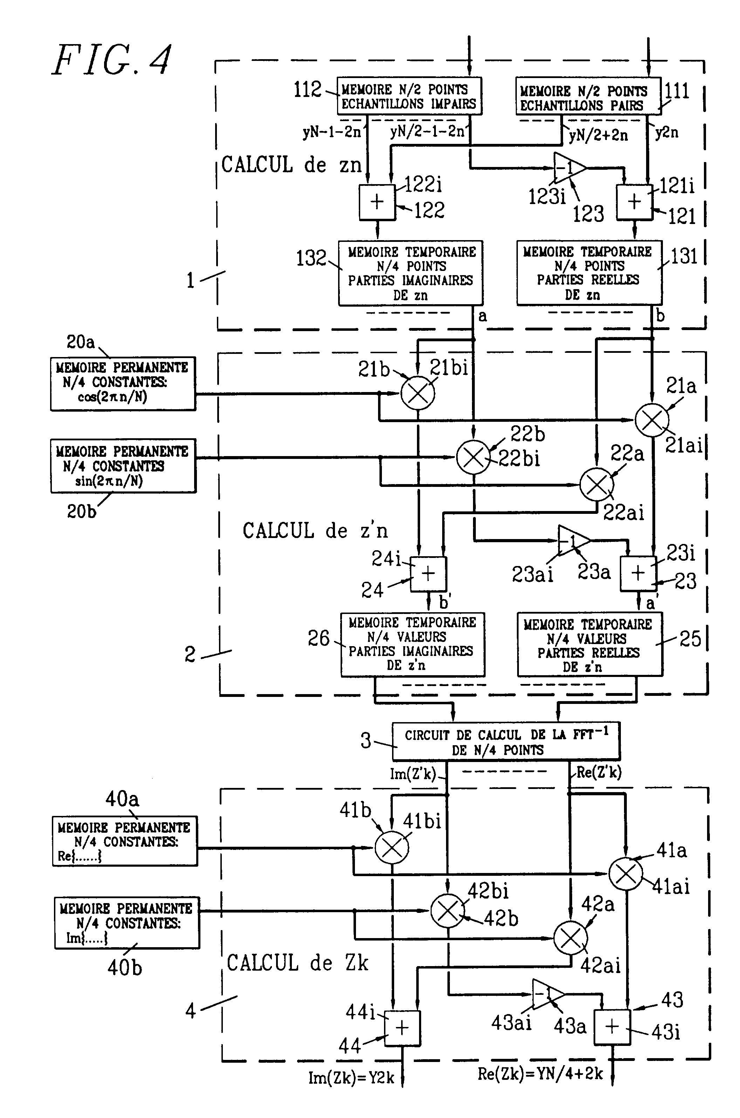

Une description plus détaillée d'un dispositif de codage d'un signal numérique conformément à l'objet de la présente invention sera maintenant donnée en liaison avec la figure 4.

Selon la figure précitée, les échantillons ainsi que décrits précédemment étant regroupés en blocs de N échantillons successifs, le dispositif comprend une première, 111, et une deuxième 112 mémoire d'entrée permettant chacune la mémorisation de N/2 échantillons successifs. A titre d'exemple non limitatif, la deuxième mémoire d'entrée 112 permet la mémorisation des échantillons retardés de N/2. Selon une autre variante de réalisation, la première mémoire d'entrée permet la mémorisation, par adressage, de N/2 échantillons ou points d'ordre pair, alors que la deuxième mémoire d'entrée 112 permet la mémorisation de N/2 points ou échantillons d'ordre impair.

Des circuits de calcul notés 1, 2, 3, 4 sur la figure 4 permettent respectivement d'effectuer :

- le calcul de zn, conformément à la relation (12),
- le calcul de z′n vérifiant la relation (13),

- le calcul de la transformée de Fourier rapide inverse $FFT^{-1}$ de N/4 selon la relation (14),
- le calcul de Zk selon la relation (15).

Bien entendu, à titre d'exemple non limitatif, les circuits de calcul 1, 2, 3, 4, effectuent ainsi, suite à l'opération de fenêtrage précédemment mentionnée, consistant en une pondération spatiale ou temporelle des échantillons, une transformée en cosinus discrète modifiée TCDM permettant notamment, successivement, l'établissement d'une transformation complexe inversible Y2k+N/4+jY2k vérifiant les relations (16) et (17) à partir de l'expression de calcul auxiliaire.

Ainsi, les circuits de calcul de la transformation complexe inversible 1, 2, 3, et 4 précédemment mentionnés comportent successivement, en cascade du dispositif de codage conformément à l'objet de la présente invention, un circuit 1 de calcul complexe permettant d'effectuer le calcul de zn, un circuit 2 de multiplication complexe permettant d'effectuer le calcul de $z'n = zn.WN^n$ pour n = 0,...,N/4-1, un circuit de calcul 3 par transformée de Fourier rapide inverse $FFT^{-1}.z'n$, c'est-à-dire l'expression Z'k vérifiant la relation (14), puis un troisième circuit 4 de calcul de l'expression de Zk vérifiant la relation (15) pour k = 0,...,N/4-1. Ce troisième circuit 4 permet ainsi la détermination successive des coefficients d'ordre pair et impair de transformation, ainsi que décrit précédemment dans la description.

Ainsi qu'on a représenté en Figure 4, le premier circuit de calcul complexe de zn comporte, connectés au première et deuxième mémoires d'entrée 111, 112 des premiers et deuxièmes circuits sommateurs, notés 121, 122.

Les premiers circuits sommateurs reçoivent, d'une part, directement de la première mémoire d'entrée, la valeur de l'échantillon pondéré y2n, et, d'autre part, de la deuxième mémoire d'entrée 112, par l'intermédiaire d'un multiplicateur par -1, noté 123, la valeur de l'échantillon pondéré yN/2-1-2n. Les deuxièmes circuits sommateurs 122i reçoivent d'une part de la première mémoire d'entrée 111 l'échantillon pondéré yN/2+2n, et d'autre part, de la deuxième mémoire d'entrée, l'échantillon pondéré yN-1-2n. On notera bien sûr que les premiers et deuxièmes circuits sommateurs 121, 122, peuvent en fait être constitués par des sommateurs élémentaires, notés 121i, 122i, chaque sommateur élémentaire recevant les couples de valeurs d'échantillons pondérés précédemment mentionnées pour constituer l'ensemble des valeurs complexes zn. Bien entendu, chaque premier circuit sommateur 121i est relié à la deuxième mémoire d'entrée 112, par l'intermédiaire d'un circuit multiplicateur par -1, noté 123i. Ainsi, les premiers circuits sommateurs 121 peuvent être formés par N/2 sommateurs élémentaires 121i. Il en est de même pour les deuxièmes circuits sommateurs 122, relativement aux sommateurs élémentaires 122i.

Le nombre de composants élémentaires, tels que les sommateurs élémentaires 121i, 122i, peut être déterminé de façon à réaliser un compromis entre vitesse de traitement et capacité de mémorisation.

En outre, le premier circuit de calcul complexe 1 comporte des premières et deuxièmes mémoires auxiliaires de N/4 valeurs, ces premières et deuxièmes mémoires auxiliaires, notées 131, 132, étant connectées en sortie des premiers et deuxièmes additionneurs 121, 122, et en particulier des sommateurs élémentaires les constituant.

Les mémoires auxiliaires 131, 132, permettent de mémoriser la partie réelle, respectivement la partie imaginaire de zn.

De la même manière, les deuxièmes circuits 2 de multiplication complexe de calcul de z'n comportent, ainsi que représenté en Figure 4, des circuits notés 20a, 20b, de mémorisation de valeurs constantes, les constantes $WN^n$. Ces circuits de mémorisation peuvent être constitués par des circuits de type mémoire RAM à accès en lecture rapide, chargés à partir de mémoires mortes contenant les valeurs constantes précitées.

En outre, des premiers circuits multiplicateurs notés 21a, 22a, sont prévus et reçoivent, d'une part, la partie réelle a de $zn = a+jb$, et d'autre part, la partie réelle $\cos 2\pi \frac{n}{N}$, respectivement la partie imaginaire $\sin 2\pi \frac{n}{N}$ de $WN^n$. Ces premiers circuits multiplicateurs délivrent les produits $a.\cos 2\pi \frac{n}{N}$ et $a.\sin 2\pi \frac{n}{N}$.

De la même manière, des deuxièmes circuits multiplicateurs notés 21b, 22b, reçoivent, d'une part, la partie imaginaire b de zn et, d'autre part, la partie réelle $\cos 2\pi \frac{n}{N}$ respectivement la partie imaginaire $\sin 2\pi \frac{n}{N}$ de $WN^n$. Ces deuxièmes circuits multiplicateurs 21b, 22b, délivrent les produits $b.\cos 2\pi \frac{n}{N}$ et $b.\sin 2\pi \frac{n}{N}$

Ainsi qu'on l'a représenté en outre en figure 4, des premiers circuits sommateurs 23 reçoivent le produit $a.\cos 2\pi \frac{n}{N}$ du premier circuit multiplicateur 21a et, d'autre part, du deuxième circuit multiplicateur 22b, le produit $b.\sin 2\pi \frac{n}{N}$ par l'intermédiaire d'un multiplicateur par -1 noté 23a. Le premier circuit sommateur 23 délivre la partie réelle de $z'n = a'+jb'$, avec

$$a' = a.\cos 2\pi \frac{n}{N} - b.\sin 2\pi \frac{n}{N}.$$

De même, un deuxième circuit sommateur 24 est prévu, et reçoit, d'une part, du premier circuit multiplicateur 22a,

le produit $a.\sin 2\pi \frac{n}{N}$ et d'autre part, du circuit multiplicateur 21b, le produit $b.\cos 2\pi \frac{n}{N}$. Ce deuxième circuit sommateur 24 délivre la partie imaginaire de zn,

$$b' = a.\sin 2\pi \frac{n}{N} + b.\cos 2\pi \frac{n}{N}.$$

La notation i des multiplicateurs et sommateurs indique une multiplicité éventuelle maximale de N/4 de ces 1 derniers dans les conditions indiquées précédemment.

En outre, les premières 25 et deuxièmes 26 mémoires auxiliaires permettent de mémoriser les valeurs de la partie réelle a', respectivement imaginaires b', de z'n. On notera que les mémoires auxiliaires précitées sont des mémoires de type RAM permettant en fait de mémoriser chacune N/4 valeurs.

Le circuit de calcul 3 permet d'effectuer une transformée de Fourier rapide inverse $FFT^{-1}$ de l'expression :

$$Z'k = FFT^{-1}.z'n.$$

Celle-ci peut être réalisée par un circuit dédié permettant la mise en oeuvre de la méthode de calcul décrite par Pierre Duhamel dans l'article précédemment mentionné.

Enfin, ainsi que représenté en figure 4, les troisièmes circuits 4 de multiplication complexe de l'expression Zk peuvent comporter des circuits notés 40a, 40b, de mémorisation des constantes $W8^{-1}$ et $W4N^{4k+1}$ selon leur partie réelle et imaginaire. On notera que d'une manière générale les mémoires permanentes de constantes telles que à 20a, 20b, respectivement 40a, 40b, ne sont pas représentées dans les circuits de calcul correspondants afin de ne pas surcharger le dessin.

Ainsi qu'on le remarquera à l'observation de la figure 4, le troisième circuit 4 de multiplication complexe comprend des éléments analogues à ceux du circuit de calcul 2 de multiplication complexe. En particulier, il comprend des premiers circuits multiplicateurs 41a, 42a, recevant, d'une part, la partie réelle de l'expression Z'k, et, d'autre part, la partie réelle respectivement imaginaire des constantes $W8^{-1}$ et $W4N^{4k+1}$ à partir des circuits de mémorisation 40a, 40b.

Les premiers circuits multiplicateurs délivrent les produits correspondants.

En outre, les deuxièmes circuits multiplicateurs 41b, 42b, reçoivent, d'une part, la partie imaginaire de l'expression Z'k et, d'autre part, la partie réelle, respectivement imaginaire, des constantes $W8^{-1}$ et $W4N^{4k+1}$ à partir des mêmes circuits de mémorisation 40a, 40b. Ils délivrent les produits correspondants.

En outre, des premier 43 et deuxième 44 circuits sommateurs sont prévus. Le premier circuit sommateur 43 reçoit le produit délivré par le premier circuit multiplicateur 41a, et le produit délivré par le deuxième circuit multiplicateur 42b, par l'intermédiaire d'un multiplicateur par -1 noté 43a. Il délivre la partie réelle de l'expression Zk, telle que

$$Re[Zk] = YN/4+2k.$$

Le deuxième circuit sommateur 44 reçoit, d'une part, le produit délivré par le premier circuit multiplicateur 42a, et, d'autre part, le produit délivré par le deuxième circuit multiplicateur 41b, et délivre la partie imaginaire de l'expression Zk :

$$Im[Zk] = Y2k.$$

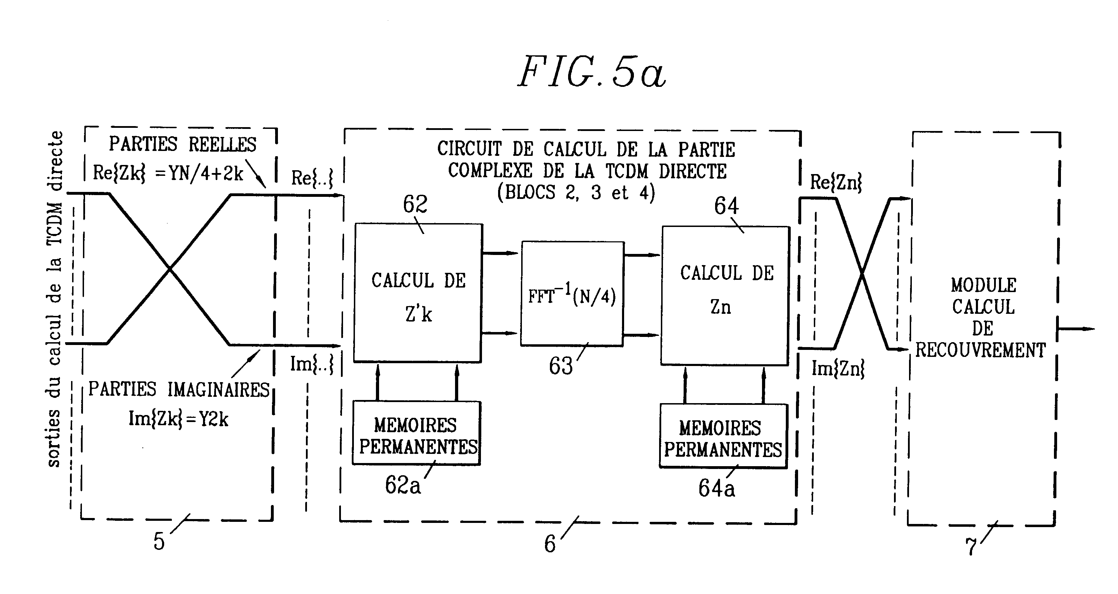

Une description plus détaillée d'un dispositif de décodage d'un signal numérique x représenté par des échantillons x(n), ces échantillons ayant été codés selon le procédé de codage précédemment décrit dans la description, sera donnée en liaison avec la figure 5a.

Ainsi qu'on l'a représenté sur la figure 5a, le dispositif de décodage comprend un circuit 5 de mémorisation et de lecture des coefficients de transformation transmis, tels qu'établis par le circuit codeur de la figure 4, ces coefficients s'écrivant :

$$YN/4+2k = Re[Zk] \text{ et } Y2k = Im[Zk]$$

Le circuit 5 de mémorisation et de lecture permet d'effectuer une permutation des coefficients de transformation transmis mémorisés, et ce, par adressage en lecture, cette permutation étant représentée par le croisement des parties réelles et imaginaires mémorisées, ainsi que représenté sur la figure 5a.

En outre, le dispositif de décodage comprend un circuit 6 de calcul de la partie complexe de la TCDM directe comprenant successivement en cascade un circuit 62 de multiplication complexe de calcul de Z'k et un circuit 63 de calcul de la transformée de Fourier inverse $FFT^{-1}$ correspondante. Un circuit 64 permet de calculer l'expression Zk :

$$Zk = (-1)^{k+1}.W8^{-1}.W4N^{4k+1}.Z'k.$$

On notera que le circuit 6 de calcul de la partie complexe de la TCDM directe comporte des modules 62, 63, et 64, respectivement identiques aux modules 2, 3 et 4 du dispositif codeur. En conséquence, ces modules ne seront pas décrits plus en détails.

En outre, ainsi que représenté en figure 5a, le dispositif de décodage comprend, après interversion ou permutation des parties réelles et imaginaires de Zk, par adressage en lecture de façon analogue à la permutation réalisée avec le module d'entrée 5 précédemment décrit, un module de calcul de recouvrement, noté 7, lequel sera décrit ci-après.

On comprendra que le module 6 de calcul de la partie complexe de la TCDM directe, par l'intermédiaire des modules 62, 63 et 64 précédemment décrits, dans lesquels le flux de l'information est traité selon un processus inverse, délivre finalement une variable complexe, notée Zn, de la forme :

$$Zn = (x2n.h2n-xN/2-2n-1.hN/2-2n-1)$$
$$+ j(xN-2n+1.hN-2n+1-xN/2+2n.hN/2+2n).$$

Dans cette relation, la partie réelle est retardée d'un demi-bloc par rapport à la partie imaginaire, soit de N/2 échantillons.

Dans la relation précitée, on suppose que la fenêtre de pondération utilisée au processus de codage et celle utilisée au processus de décodage sont identiques.

Après compensation du retard précité, la relation précédente peut être écrite sous la forme :

$$Zn = (x2n+jxN/2-2n+1)(h2n+jh(N/2+2n)).$$

Les conditions de reconstruction parfaite des échantillons d'origine précédemment mentionnées dans la description permettent alors de reconstruire la séquence des échantillons x(n) par une simple multiplication complexe de l'expression précitée de zn par l'expression :

$$h2n-jhN/2+2n.$$

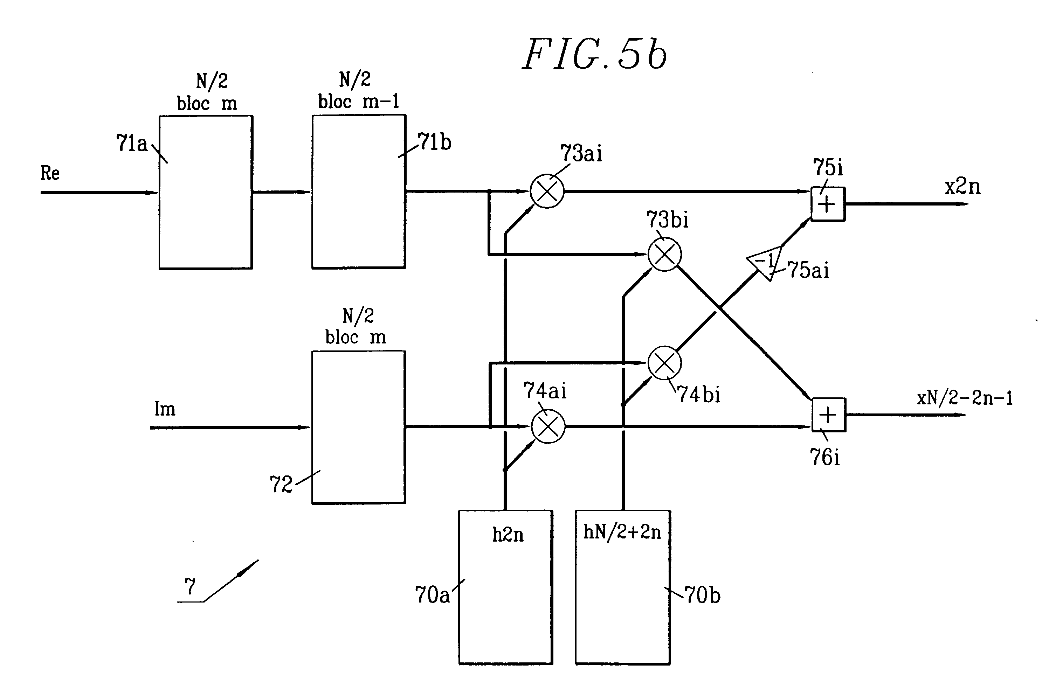

Ainsi qu'on l'a représenté en figure 5b, le module de calcul de recouvrement 7 comprend une première, 71a, et une deuxième, 71b, mémoires de N/2 échantillons permettant de mémoriser les échantillons correspondants des blocs m, respectivement m-1, afin d'assurer la compensation du retard de N/2 échantillons de la partie réelle par rapport à la partie imaginaire correspondante de l'expression précitée. Les N/2 échantillons de la partie imaginaire du bloc m sont mémorisés au niveau d'une mémoire 72.

En outre, le module 7 de calcul du recouvrement comporte, ainsi que décrit précédemment, relativement au circuit de multiplication complexe, tel que 2 et 4 par exemple, ou respectivement 62, 64, des multiplicateurs 73ai, 73bi, 74ai, 74bi, un inverseur de signe 75ai et 2 sommateurs 75i, 76i.

En outre, les coefficients multiplicatifs h2n et hN/2+2n sont mémorisés dans des mémoires 70a et 70b. On comprendra bien sur que dans le mode de réalisation du module représenté en figure 5b, les multiplicateurs et sommateurs portant les indices i n'ont été représentés qu'à un exemplaire, afin de ne pas surcharger le dessin, ce nombre de multiplicateurs et sommateurs pouvant être égal à N/2, afin de réaliser les opérations correspondantes sur les N/2 valeurs mémorisées correspondantes.

Les sommateurs 75i, respectivement 76i, délivrent alors les échantillons reconstitués, x2n, respectivement xN/2-2n-1.

Dans un mode de réalisation amélioré de mise en oeuvre du procédé et du dispositif de codage respectivement de décodage objets de la présente invention, ces derniers peuvent avantageusement permettre la prise en compte directe du fenêtrage et du recouvrement dans le processus de calcul.

En effet, on peut remarquer, d'une part que la structure du processus de calcul montre que la fenêtre autorisant une reconstruction parfaite réalise en fait une rotation des deux parties d'échantillons de rang pair, respectivement impair, de la suite d'échantillons x(n) d'entrée. En outre, en ce qui concerne le calcul du recouvrement, au niveau de la reconstruction des échantillons au niveau du décodeur, la propriété de reconstruction parfaite, due au seul fait du recouvrement de N/2 échantillons des blocs d'échantillons, permet, après compensation du retard de N/2 échantillons, d'obtenir la séquence d'échantillons reconstruits x2n par une multiplication complexe par l'expression

$$h2n - jhN/2+2n.$$

L'utilisation de la fenêtre telle que définie par la relation (6) permet alors de simplifier notablement le processus de codage respectivement de décodage mis en oeuvre conformément à l'objet de la présente invention, compte tenu de l'observation selon laquelle l'opérateur défini par la relation (6), définissant la fenêtre de pondération appliquée aux échantillons, lors de l'opération de pondération des échantillons d'entrée x(n) respectivement de l'opération de reconstruction des échantillons x2n, n'est autre que la racine 4Nième de l'unité à la puissance 4n+1, $W4N^{4n+1}$.

Dans les processus de codage, respectivement de décodage, on note que la relation (15) est obtenue par une opération de rotation semblable appliquée sur les coefficients Z'k obtenus après traitement 3 par transformée de Fourier rapide inverse $FFT^{-1}$.

Ainsi le fenêtrage 1 et la multiplication complexe 2 de calcul de z'n du processus de traitement avec

$$c = \cos 2\pi \, \frac{4n+1}{4N} \text{ et } s = \sin 2\pi \, \frac{4n+1}{4N}$$

peuvent-ils être exprimés par la relation :

$$(18) \qquad z'n = ((x2n.c-xN/2-1-2n.s)$$

$$+ j.zo^{-N/2}.(x2n.s+xN/2-2n-1.c)).(c+js)$$

soit

$$(19) \qquad z'n = zo^{-N/2}.(x2n.s^2+xN/2-1-2n.cs)$$

$$+ j(x2n.cs-xN/2-1-2n.c^2)$$

la relation $c^2=1-s^2$ permet d'obtenir la relation :

$$(20) \qquad z'n = (x2n-j.xN/2-1-2n) + (-(x2n.s^2+xN/2-2n-1.cs)$$

$$+ j(x2n.cs+xN/2-1-2n.c^2))$$

$$+ zo^{-N/2}.((x2n.s^2+xN/2-2n-1.cs)$$

$$+ j(x2n.cs+xN/2-2n-1.c^2))$$

Dans les relations précitées, on rappelle que $zo^{-N/2}$ représente l'opérateur de retard de N/2 échantillons appliqué aux échantillons ou valeurs d'ordre n courant.

Ainsi , le processus précité tel que décrit compte tenu du fenêtrage particulier ne fait-il intervenir que deux quantités nouvelles à chaque bloc de N échantillons, les quantités

$$(x2n.s^2+xN/2-2n-1.cs)$$

et

$$(x2n.cs+xN/2-2n-1.c^2).$$

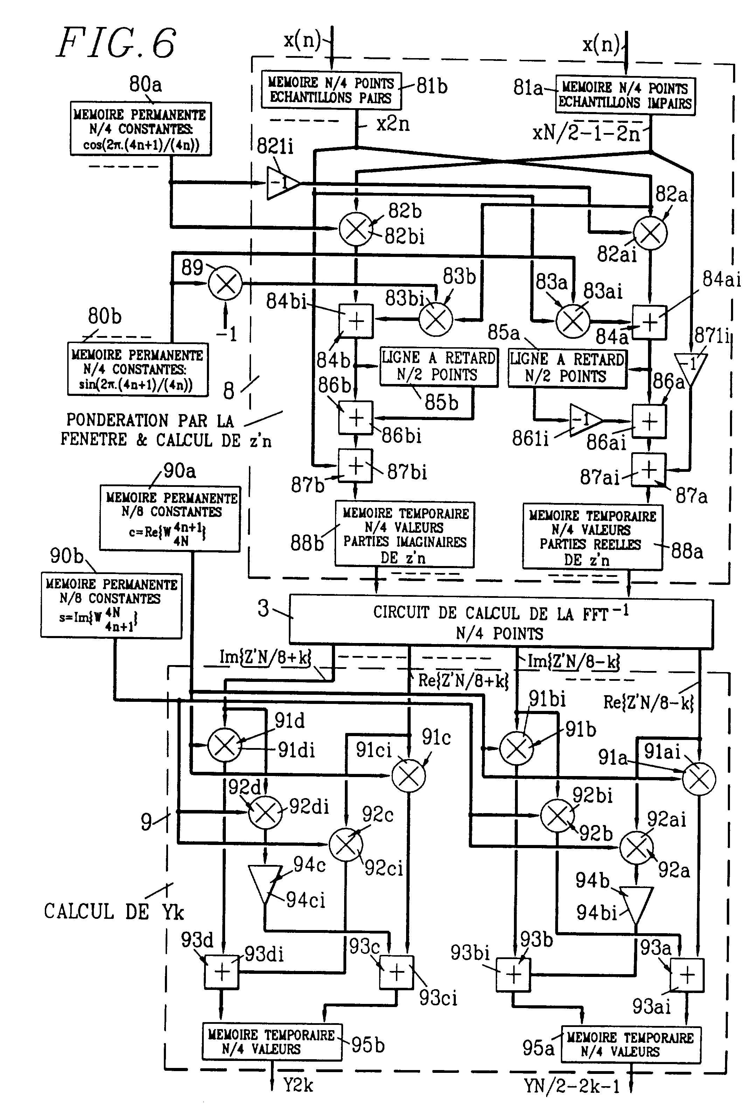

La mémorisation de N/4 valeurs supplémentaires permet alors, dans un mode de réalisation d'un codeur ou d'un décodeur conforme à l'objet de la présente invention tel que décrit en figure 6, de ramener l'ensemble des deux rotations, fenêtrage réalisé en amont du processus de calcul 1 de zn, multiplication complexe en 2 pour le calcul de z'n en Figure 4, l'ensemble de ces deux traitement de rotation nécessitant 3N opérations, à N multiplications et N additions, soit 2N opérations, le coût en nombre d'opérations relatives au fenêtrage étant ainsi en apparence supprimé.

On notera que dans le processus de codage tel que représenté en figure 6, le dispositif permettant la mise en oeuvre d'un tel processus comporte un module 8 de fenêtrage et de calcul de z'n remplaçant le module de fenêtrage, non représenté, le module 1 de calcul de zn et le module 2 de multiplication complexe de calcul de z'n de la figure 4. Le module 8 est suivi du module 3 de calcul de la transformée de Fourier rapide inverse $FFT^{-1}$ sur N/4 points, ce dernier étant lui-même suivi d'un module 9 de calcul des coefficients pairs de transformée Y2k puis respectivement impairs YN/2-2k-1.

Sur la figure 6, on a représenté successivement les modules 8, 3 et 9 précédemment mentionnés. On notera que, conformément à la convention précédemment établie, tout opérateur, multiplicateur ou sommateur porte une référence chiffrée générale, laquelle, lorsqu'elle est assortie d'un indice i, correspond à un opérateur élémentaire, une pluralité d'opérateurs élémentaires pouvant constituer l'opérateur précité. Ainsi, dans les modules 8 et 9 de la figure 6, tout indice i peut indiquer en fait une pluralité de N/4 opérateurs élémentaires correspondants, ce qui permet la réalisation d'un dispositif de codage, ou respectivement de décodage, permettant un fonctionnement en temps réel pour une capacité de mémorisation optimisée.

Ainsi qu'on l' a représenté sur la figure précitée, le module 8 de fenêtrage et de calcul de z'n comporte une première mémoire d'entrée 81a et une deuxième mémoire d'entrée 81b, permettant respectivement de mémoriser les échantillons impairs, respectivement pairs, x(n).

Des premiers multiplicateurs 82a, respectivement 82b, reçoivent respectivement les échantillons mémorisés x2n délivrés par la mémoire 81b, et les échantillons impairs xN/2-1-2n délivrés par la mémoire 81a. Les premiers multiplicateurs précités reçoivent également, respectivement à partir d'une mémoire auxiliaire 80a, la valeur de la constante c, précédemment mentionnée dans la description, par l'intermédiaire d'un inverseur 821i et directement.

En outre, des deuxièmes multiplicateurs, notés 83a, respectivement 83b, reçoivent, outre les échantillons pairs x2n, respectivement impairs xN/2-1-2n, de la part d'une mémoire auxiliaire notée 80b, la valeur de la constante s précédemment décrite dans la description, respectivement directement et par l'intermédiaire d'un multiplicateur par -1 noté 89.

Des premiers sommateurs 84a et 84b reçoivent, d'une part, le produit délivré par le premier multiplicateur 82a et par le deuxième multiplicateur 83a, et d'autre part, le produit délivré par le premier multiplicateur 82b, et par le deuxième multiplicateur 83b.

Des deuxièmes sommateurs notés 86a, respectivement 86b, reçoivent respectivement la somme délivrée par les premiers sommateurs 84a ainsi que cette même somme retardée par une ligne à retard de N/2 valeurs, notée 85a, par l'intermédiaire d'un inverseur noté 861i, et d'autre part, la somme délivrée par le premier sommateur 84b, et cette même somme retardée de N/2 valeurs, par une ligne à retard 85b.

Des troisièmes sommateurs notés 87a et 87b reçoivent respectivement les sommes délivrées par les deuxièmes sommateurs 86a, respectivement 86b, ainsi que, respectivement la valeur de l'échantillon impair xN/2-1-2n après inversion par un inverseur noté 871i et la valeur de l'échantillon d'ordre pair x2n. Les troisièmes sommateurs 87a et 87b délivrent ainsi les valeurs correspondantes de z′n, les troisièmes sommateurs 87a délivrant les parties réelles de z′n et les troisièmes sommateurs 87b délivrant les parties imaginaires de z′n. On notera que les mémoires 88a et 88b peuvent avantageusement être constituées par des mémoires de type RAM de N/4 valeurs.

Le module 3 de calcul de la transformée de Fourier rapide inverse $FFT^{-1}$ est identique au module 3 de la figure 4.

Le module 9 de calcul des coefficients de transformée Yk permet alors de calculer les valeurs des coefficients pairs Y2k, respectivement impairs YN/2-2k-1 à partir des valeurs de la transformée de Fourier rapide précédemment citées.

Ainsi qu'on l'a représenté en figure 6, le module 9 comprend des premiers multiplicateurs notés 91a, 91b, 91c, et 91d. Les premiers multiplicateurs reçoivent respectivement dans l'ordre de leur énonciation la partie réelle des résultats de la transformée de Fourier rapide notée Re[Z′N/8-k], la partie imaginaire correspondante notée Im[Z′N/8-k], la partie réelle Re[Z′N/8+k] et enfin, la partie imaginaire correspondante Im[Z′N/8+k]. Les premiers multiplicateurs précités reçoivent, en outre, la valeur c précédemment mentionnée dans la description d'une mémoire auxiliaire 90a.

Le module 9 de calcul des coefficients des transformées comporte en outre des deuxièmes multiplicateurs notés respectivement 92a, 92b, 92c et 92d. Les deuxièmes multiplicateurs reçoivent dans l'ordre de leur énonciation respectivement les produits de la transformée de Fourier rapide inverse, de même que les premiers multiplicateurs précédemment énoncés, et la valeur s précédemment mentionnée dans la description à partir d'une mémoire auxiliaire notée 90b. Les deuxièmes multiplicateurs délivrent les produits correspondants.

Des premiers sommateurs 93a, deuxièmes sommateurs 93b, troisièmes sommateurs 93c et quatrièmes sommateurs 93d reçoivent respectivement : les valeurs des produits délivrées par le premier multiplicateur 91a, et le deuxième multiplicateur 92b ; le deuxième multiplicateur 92a, par l'intermédiaire d'un inverseur 93b, et le produit délivré par le premier multiplicateur 91b, le produit délivré par le premier multiplicateur 91c, et le produit délivré par le deuxième multiplicateur 92d par l'intermédiaire d'un inverseur 94c ; et enfin le produit délivré par le deuxième multiplicateur 92c, et par le premier multiplicateur 91d. Les sommes délivrées par le premier sommateur 93a et le troisième sommateur 93c sont mémorisées au niveau d'une mémoire auxiliaire 95a, laquelle constitue une mémoire des valeurs des coefficients de transformée de rang impair YN/2-2k-1. Au contraire, une mémoire auxiliaire 95b reçoit les valeurs délivrées par le deuxième sommateur 93b et par le quatrième sommateur 93d, cette mémoire auxiliaire 95b permettant de mémoriser les coefficients de transformée de rang pair Y2k.

On comprendra ainsi que le module de codage, tel que représenté en figure 6, permet un gain particulièrement avantageux en temps de calcul, le nombre d'opérations étant ramené ainsi que mentionné précédemment de 3N opérations à 2N opérations, un nombre d'opérations correspondant à celles nécessaires au fenêtrage dans le mode de réalisation de la figure 4 étant ainsi supprimé.

On notera bien sûr qu'un décodeur peut être réalisé à partir de la même configuration que celle représentée en figure 6 conformément au principe de transformation inversible déjà mentionnée en relation avec les figures 4 et 5a. Une description détaillée de ce décodeur ne sera pas donnée, car, bien entendu, il suffit, en pratique, de substituer les variables d'entrée et de sortie correspondantes pourvu que l'on termine par la série de multiplications par les valeurs de rotation c et s précédemment citées.

En outre, un listage du code source d'un programme permettant d'assurer le traitement des échantillons x(n) tant au niveau du codage que du décodage est donné en annexe à la présente description. Ce traitement correspond, dans le mode de réalisation donné, à celui du dispositif de la figure 6. Le code source du programme précité a été écrit en langage C, une traduction des lignes de commentaire étant donnée, les instructions étant reproduites en l'état.

## ANNEXE A LA DESCRIPTION

```
/*      forward TDAC. declarations are omitted  */

/*  *****initialisations***** */
if(init ==0)
{
for (i = 0;i < N/4;i++)
{
/*      Twiddle factors for the FFT (size N/4) */
tw1[i] = cos(8.0*pi*(float)i/(float)N);
tw2[i] = sin(8.0*pi*(float)i/(float)N);
/*      constants for the input and output rotations */
theta = 2.0*pi*(4*(float)i+1)/(4 0*(float)N);
cc[i] = cos(theta)*cos(theta);
cs[i] = cos(theta)*sin(theta);
}
for (i=1;i<N/8+1;i++)
{
theta = 2.0*pi*(float)i/(float)N;
wcos[i] = cos(theta);
wsin[i] = sin(theta);
}
init = 1;
}
/*  ***** Fast Algorithm ***** */
for (i = 0;i < N/4;i++)
{
A = x[2*i]*cs[i] - x[N/2-1-2*i]*cc[i];
B = x[2*i]*(1.0-cc[i]) - x[N/2-1-2*i]*cs[i];
ycr[i] = memr[i] - x[N/2-1-2*i] - A;
yci[i] = memu[i] + x[2*i] - B;
memr[i] = A;
memu[i] = B;
}
sign = -1;
fft(ycr,yci,tw1,tw2,N/4,sign);
for(k = 1;k < N/8+1;k++)
{
A = ycr[N/8-k];
ycr[N/8-k] = A*wcos[k]+yci[N/8-k]*wsin[k];
yci[N/8-k] = yci[N/8-k]*wcos[k]-A*wsin[k];
A = ycr[N/8+k];
ycr[N/8+k] = A*wcos[k]-yci[N/8+k]*wsin[k];
yci[N/8+k] = yci[N/8+k]*wcos[k]+A*wsin[k];
}
for(k = 0;k < N/4;k++)
{
y[2*k] = -yci[k];
y[N/2-2*k-1] = ycr[k];
}
```

/* TDAC directe les déclarations sont omises */

/* **** initialisations ****  */

/* Facteurs de multiplication pour la FFT$^{-1}$ (de taille N/4)  */

/* Constantes pour les rotations d'entrée et de sortie  */

/* **** Algorithme rapide *** */

## Revendications

1. Procédé de codage d'un signal numérique (x) représenté par des échantillons numériques x(n), lesdits échantillons étant regroupés en blocs de N échantillons successifs, puis soumis à une opération de fenêtrage consistant à effectuer une pondération spatiale ou temporelle des échantillons, fonction de l'ordre n des échantillons, dans le bloc, yn = x(n).h(N-1-n) où h(N-1-n) représente une loi de pondération déterminée, ce procédé étant caractérisé en ce qu'il consiste :

   - à effectuer une transformée en cosinus discrète modifiée TCDM, au niveau des blocs d'échantillons, pour calculer les coefficients de transformation d'ordre pair de la forme :

$$Y2k = \sum_{n=0}^{N-1} yn.Cos(2\pi/(4N).(2n+1)(4k+1)+(4k+1)\pi/4)$$

pour $k \in [0,...,N/2-1]$ avec YN-k = -Yk-1,

le terme de déphasage étant réparti en fonction de l'ordre k du coefficient précité,

- à exprimer lesdits coefficients d'ordre pair calculés Y2k sous forme d'une transformation complexe inversible

$$Y2k+N/4+jY2k$$

$$= (-1)^{k+1}.W8^{-1}.\sum_{n=0}^{N/4-1} ((y'n-y''n+N/4)+j(y''n+y'n+N/4))$$

$$.W4N^{(4k+1)(4n+1)}$$

pour k=0,...,N/4-1

avec

$$y'n = x2n.h2n$$
$$y''n = xN-2n-1.hN-2n-1$$
$$W4N = Cos(2\pi/4N)+j.sin(2\pi/4N),$$

- à calculer ladite transformation complexe inversible à partir de l'expression de calcul auxiliaire:

$$Zk = (-1)^{k+1}.W8^{-1}.W4N^{4k+1}.\sum_{n=0}^{N/4-1} (zn.WN^n).WN/4^{nk}$$

où

$$zn = (y2n-yN/2-1-2n)+j(yN-1-2n+yN/2+2n)$$

pour n=0,...,N/4-1.

2. Procédé selon la revendication 1, caractérisé en ce que le calcul de ladite transformation complexe inversible est effectué par les étapes successives suivantes :

    a) calcul de zn pour n=0,...N/4-1

    b) calcul de $z'n=zn.WN^n$ pour n=0,...,N/4-1

    c) calcul par transformée de Fourier rapide inverse, $FFT^{-1}$, de taille N/4 des coefficients correspondants Z'k :

$$Z'k = FFT^{-1}.z'n$$

    d) calcul de l'expression :

$$Zk = ((-1)^{k+1}.W8^{-1}.W4N^{4K+1}).Z'k$$

    pour k=0,...N/4-1

    e) détermination successive des coefficients de transformation d'ordre pair,

        Y2k Im[Zk] partie imaginaire de Zk,

        Y2k+N/4 Re[Zk] partie réelle de Zk

    f) transmission en lieu et place des échantillons numériques x(n) constituant le signal numérique N desdits coefficients de transformation

$$Y2k, Y2k+N/4$$

sous forme de signal codé.

3. Procédé selon la revendication 2, caractérisé en ce que l'expression de calcul auxiliaire étant exprimée sous la forme :

$$Zn = (-1)^{k+1}.W8^{-1}.WN^{k}. \sum_{n=0}^{N/4-1} (znW4N^{(4n+1)}.WN/4^{nk})$$

les étapes b) et d) sont interverties, les multiplications complexes par $W4N^{(4n+1)}$ étant placées en début ou en fin de calcul.

4. Procédé de décodage d'un signal numérique (x) représenté par des échantillons numériques x(n), lesdits échantillons étant regroupés en blocs de N échantillons, et codés selon l'une des revendications 1 à 3 précédentes, caractérisé en ce que ledit décodage consiste :

- à effectuer une permutation des parties réelles YN/4 + 2k et imaginaire Y2k des coefficients de transformation transmis,
- à soumettre lesdits coefficients permutés à un processus de traitement de codage par calcul de la partie complexe de la TDCM directe, de la forme Re[Zk], Im[Zk],
- à permuter les parties réelles et imaginaires de ladite partie complexe,
- à effectuer un calcul de recouvrement pour restituer lesdits échantillons x(n).

5. Procédé selon la revendication 4, caractérisé en ce que ledit processus de traitement identique au processus de traitement de codage par calcul de la partie complexe de la TCDM directe comprend :

- calcul de

$$z'n = zn.WN^{n}$$

pour n = 0,...,N/4-1,
- calcul de Z'k par transformée de Fourier rapide inverse, $FFT^{-1}$, de taille N/4,

$$Z'k = FFT^{-1}.z'n,$$

- calcul de l'expression

$$Zk = ((-1)^{K+1}.W8^{-1}.W4N^{4k+1}).Z'k$$

pour k=0,....,N/4-1

6. Procédé selon la revendication 5, caractérisé en ce que l'ensemble des étapes b), c) et d) formant une transformation complexe inversible, l'inverse de la transformée constituée par les étapes précitées constitue le noyau d'une transformée en cosinus discrète modifiée inverse, TCDM inverse, cette TDCM inverse étant calculée au moyen d'une TCDM directe correspondante suite à :

- interversion des parties réelles et imaginaires des signaux d'entrée, z = a+jb ==> z* = b+ja pour engendrer des signaux d'entrée inversés,
- calcul de la TCDM directe des signaux d'entrée inversés pour engendrer des signaux de sortie , Y*k,
- interversion des parties réelles et imaginaires des signaux de sortie Y*k pour engendrer des signaux de sortie inverse Yk.

7. Dispositif de codage d'un signal numérique (x) représenté par des échantillons numériques x(n), regroupés en blocs de N échantillons successifs, caractérisé en ce que ledit dispositif comporte :

- une première (111) et une deuxième (112) mémoires d'entrée permettant chacune la mémorisation de N/2 échantillons successifs, ladite deuxième mémoire d'entrée permettant la mémorisation desdits échantillons retardés de N/2,
- des moyens de calcul (1, 2, 3, 4), suite à une opération de fenêtrage consistant à effectuer une pondération spatiale des échantillons yn = x(n).h(N-1-n) où h(N-1-n) représente une loi de pondération déterminée, sur lesdits échantillons, d'une transformée en cosinus discrète modifiée TCDM, de façon à calculer les coefficients de transformée d'ordre pair de la forme :

$$Y2k = \sum_{n=0}^{N-1} yn.\cos(2\pi/(4N).(2n+1).(4k+1)+(4k+1)\pi/4)$$

pour k ∈ [0,...,N/2-1]
avec

$$YN-k = -Yk-1,$$

le terme de déphasage étant réparti en fonction de l'ordre k du coefficient considéré,

les coefficients d'ordre pair Y2k étant obtenus à partir d'une transformation complexe inversible Y2k+N/4+jY2k, à partir d'une expression de calcul auxiliaire

$$Zk = (-1)^{k+1}.W8^{-1}.W4N^{4k+1}.\sum_{n=0}^{N/4-1}(zn.WN^{n}).WN/4^{nk}$$

où

$$zn = (y2n-yN/2-1-2n) + j(yN-1-2n+yN/2+2n)$$

pour n = 0,...,N/4-1

8. Dispositif selon la revendication 7, caractérisé en ce que lesdits moyens de calcul de la transformation complexe inversible Y2K+N/4+jY2k comportent successivement en cascade :

- des premiers moyens (1) de calcul complexe permettant d'effectuer le calcul de zn,
- des deuxièmes moyens (2) de calcul complexe de

$$z'n = zn.WN^{n},$$

pour n = 0,...,N/4-1,
- des moyens (3) de calcul par transformée de Fourier rapide inverse $FFT^{-1}.z'n$,
- des troisièmes moyens (4) de calcul complexe de l'expression

$$Zk = (-1)^{k+1}.W8^{-1}.W4N^{4k+1}.Z'k$$

pour k = 0,...,N/4-1
et de détermination successive des coefficients de transformation d'ordre pair
Y2k Im[Zk] partie imaginaire de Zk,
Y2k+N/4 Re[Zk] partie réelle de Zk.

9. Dispositif selon l'une des revendications 7 ou 8, caractérisé en ce que lesdits premiers moyens (1) de calcul complexe de zn comportent, connectés auxdites première et deuxième mémoires d'entrée (111), (112) :

- des premiers et deuxièmes moyens sommateurs (121, 122), lesdits premiers moyens sommateurs (121) recevant, d'une part, directement de ladite première mémoire d'entrée, la valeur de l'échantillon pondéré y2n, et, d'autre part, de la deuxième mémoire d'entrée (112), par l'intermédiaire d'un multiplicateur par -1, (123), la valeur de l'échantillon pondéré yN/2-1-2n, lesdits deuxièmes moyens sommateurs (122) recevant, d'une part, de ladite première mémoire d'entrée l'échantillon pondéré yN/2+2n, et, d'autre part, de ladite deuxième mémoire d'entrée, l'échantillon pondéré yN-1-2n,
- des premières et deuxièmes mémoires auxiliaires de N/4 points connectées respectivement en sortie des premiers et deuxièmes additionneurs et permettant de mémoriser la partie réelle, respectivement imaginaire, de
$$zn = (y2n-yN/2-1-2n) + j(yN-1-2n+yN/2+2n).$$

10. Dispositif selon l'une des revendications 7 à 9, caractérisé en ce que lesdits deuxièmes moyens (2) de multiplication complexe de calcul de Z'n comportent :

- des moyens (20a, 20b) de mémorisation de constantes

$$WN^{n} = \cos 2\pi n/N + j.\sin 2\pi n/N,$$

- des premiers moyens multiplicateurs 21a, 22a recevant, d'une part, la partie réelle a de zn = a+jb et, d'autre part, la partie réelle $\cos 2\pi n/N$, respectivement la partie imaginaire $\sin 2\pi n/N$ de $WN^{n}$, et délivrant les produits a.cos2πn/N et a.sin2πn/N,
- des deuxièmes moyens multiplicateurs recevant, d'une part, la partie imaginaire b de 2n = a+jb, et, d'autre part, la partie réelle cos 2πn/N respectivement la partie imaginaire sin2πn/N de W/n et délivrant les produits b.cos2πn/N et b.sin2πn/N,
- des premiers moyens sommateurs (23) recevant, d'une part, du premier moyen multiplicateur (21a), le produit a.cos2πn/N, et, d'autre part, du deuxième moyen multiplicateur 22b, le produit b.sin2πn/N par l'intermédiaire d'un multiplicateur par -1 (23a) et délivrant la partie réelle de z'n = a'+jb',

$$a'=a.\cos2\pi n/N - b.\sin2\pi n/N,$$

- des deuxièmes moyens sommateurs (24) recevant, d'une part, du premier moyen multiplicateur (22a) le produit a.sin2πn/N, et, d'autre part, du deuxième moyen multiplicateur (21b) le produit b.cos2πn/N et délivrant la partie imaginaire de z'n=a'+jb', b'=a.sin2πn/N + b.cos2πn/N,
- des premières et deuxièmes mémoires auxiliaires (25, 26) permettant de mémoriser les valeurs de la partie réelle a' respectivement imaginaire b' de z'n.

**11.** Dispositif selon l'une des revendications 7 à 10, caractérisé en ce que lesdits troisièmes moyens (4) de calcul complexe de Z'k comprennent :

- des moyens (40a, 40b) de mémorisation des constantes $W8^{-1}$, $W4N^{4k+1}$, selon leur partie réelle et imaginaire,
- des premiers moyens multiplicateurs (41a, 42a) recevant, d'une part, la partie réelle de l'expression Z'k, et, d'autre part, la partie réelle respectivement imaginaire desdites constantes $W8^{-1}$, $W4N^{4k+1}$ des moyens de mémorisation (40a, 40b) et délivrant les produits correspondants,
- des deuxièmes moyens multiplicateurs (41b, 42b) recevant, d'une part, la partie imaginaire de l'expression Z'k, et, d'autre part, la partie réelle, respectivement imaginaire, desdites constantes $W8^{-1}$, $W4N^{4k+1}$ des moyens de mémorisation (40a, 40b) et délivrant les produits correspondants,
- des premiers moyens sommateurs (43) recevant, d'une part, le produit délivré par le premier moyen multiplicateur (41a) et le produit délivré par ledit deuxième moyen multiplicateur (42b) par l'intermédiaire d'un multiplicateur par -1 (43a) et délivrant la partie réelle de l'expression Zk telle que

$$\mathrm{Re}[Zk] = YN/4+2k,$$

- des deuxièmes moyens sommateurs (44) recevant, d'une part, le produit délivré par le premier moyen multiplicateur (42a), et, d'autre part, le produit délivré par le deuxième moyen multiplicateur (41b) et délivrant la partie imaginaire de l'expression Zk telle que

$$\mathrm{Im}[Zk]=Y2k.$$

**12.** Dispositif de décodage d'un signal numérique (x) représenté par des échantillons numériques x(n), regroupés en blocs de N échantillons successifs, ces échantillons ayant été codés au moyen du dispositif de codage selon l'une des revendications 7 à 11, caractérisé en ce que ledit dispositif de décodage comporte :

- des moyens (5) de mémorisation et de lecture des coefficients de transformation transmis,

$$YN/4+2k = \mathrm{Re}[Zk] \text{ et } Y2k = \mathrm{Im}[Zk],$$

lesdits moyens de lecture permettant une permutation desdits coefficients de transformation transmis mémorisés,
- des moyens (6) de calcul de la partie complexe de la TCDM directe comportant successivement en cascade des moyens (62) de multiplication complexe de calcul de z'n, des moyens (63) de calcul de la transformée de Fourier rapide inverse $FFT^{-1}$.z'n, et des moyens (64) de calcul de l'expression

$$Zk = (-1)^{k+1}.W8^{-1}.W4N^{4k+1}.Z'k.$$

**13.** Dispositif selon la revendication 12, caractérisé en ce que lesdits moyens (6) de calcul de la partie complexe de la TCDM directe comportent des modules (62), (63) et (64) respectivement identiques aux modules (2), (3) et (4) du dispositif codeur.

**14.** Dispositif de codage respectivement de décodage d'un signal numérique (x) représenté par des échantillons x(n) regroupés en blocs de N échantillons successifs, caractérisé en ce que ce dispositif comporte :

- des premiers moyens (8) de calcul par multiplication complexe d'une expression

$$z'n = ( (x2n.c - xN/2-1-2n.s)$$

$$+ \, j.zo^{-N/2}.(x2n.s + xN/2\text{-}2n\text{-}1.c)).(c+js)$$

à partir des échantillons pairs x2n respectivement impairs xN/2-1-2n où

$$c = \cos 2\pi \, \frac{4n+1}{4N} \text{ et } s = \sin 2\pi \, \frac{4n+1}{4N}$$

- des moyens (3) de traitement par transformée de Fourier rapide inverse FFT$^{-1}$ de l'expression z'n délivrant respectivement les expressions

$$Z'(N/8\text{-}k) = FFT^{-1}.z'n \, ,$$

- des deuxièmes moyens (9) de calcul par multiplication complexe des coefficients pairs Y2k respectivement impairs YN/2-2K-1 de la transformée.

**15.** Dispositif selon la revendication 14, caractérisée en ce que lesdits premiers moyens (8) de calcul par multiplication complexe comprennent :

- une première (81a) et une deuxième (81b) mémoire d'entrée permettant de mémoriser les échantillons de rang impair x N/2-1-2n respectivement pair x2N,
- une première (80a) et deuxième (80b) mémoire permanente de mémorisation des valeurs c et s précitées,
- des premiers (82a), (82b) moyens multiplicateurs recevant d'une part les échantillons pairs x2n respectivement impairs xN/2-1-2n, et, d'autre part la valeur c par l'intermédiaire d'un multiplicateur par -1 respectivement directement,
- des deuxièmes moyens multiplicateurs (83a),(83b) recevant les échantillons pairs respectivement impairs, la valeur de la constante s, respectivement directement et par l'intermédiaire d'un multiplicateur par - 1 (89), de la part de la mémoire (80b),
- des premiers moyens (84a, 84b) sommateurs recevant le produit délivré par le premier (82a) et le deuxième (83a) multiplicateur, respectivement le premier (82b) et le deuxième multiplicateur (83b),
- des deuxièmes moyens sommateurs (86a, 86b) recevant d'une part directement la somme délivrée par les premiers sommateurs (84a) et d'autre part par l'intermédiaire d'une ligne à retard (85a), et d'un inverseur (861i), respectivement directement et par l'intermédiaire d'une ligne à retard (85b), la somme délivrée par le premier sommateur (84b),
- des troisièmes moyens sommateurs (87a) recevant, d'une part, les échantillons impairs, par l'intermédiaire d'un inverseur (871i), et, d'autre part, la somme délivrée par les deuxièmes moyens sommateurs (86a), respectivement, d'une part les échantillons pairs, et, d'autre part, la somme délivrée par le deuxième moyen sommateur (86b), les troisièmes moyens sommateurs (87a, 87b) délivrant la partie réelle de respectivement imaginaire de z'n.
- des premières et deuxièmes mémoires de type RAM (88a, 88b) recevant lesdites parties réelles respectivement imaginaires de z'n.

**16.** Dispositif selon la revendication 14, caractérisé en ce que lesdits deuxièmes moyens (9) de calcul par multiplication complexe des coefficients pairs Y2k, respectivement impairs YN/2-2k-1, de transformée comportent :

- des premières et deuxièmes mémoires permanentes (90a, 90b) des valeurs de c et s,
- des premiers multiplicateurs (91a, 91b, 91c, 91d) recevant, dans l'ordre de leur énonciation, la partie réelle Re [Z'N/8-k], la partie imaginaire Im [Z'N/8-k], la partie réelle Re [Z'N/8+k], la partie imaginaire Im [Z'N/8+k] de la transformée de Fourier rapide inverse de z'n, FFT$^{-1}$.z'n, lesdits premiers moyens multiplicateurs recevant de la première mémoire (90a) la valeur de c,
- des deuxièmes moyens multiplicateurs (92a, 92b, 92c, 92d) recevant, dans l'ordre de leur énonciation, la partie réelle Re[Z'N/8-k], la partie imaginaire Im [Z'N/8-k], la partie réelle Re [Z'N/8+k], et la partie imaginaire Im [Z'N/8-k] de la transformée de Fourier rapide inverse de z'n, FFT$^{-1}$.z'n, lesdits deuxièmes moyens multiplicateurs recevant de la deuxième mémoire (90b) la valeur de s,
- des premiers (93a), deuxièmes (93b), troisièmes (93c) et quatrième (93d) moyens sommateurs, recevant respectivement les produits délivrés par le premier multiplicateur (91a) et le deuxième multiplicateur (92b), le deuxième multiplicateur (92a) par l'intermédiaire d'un inverseur (93b) et par le premier multiplicateur (91b), le premier multiplicateur (91c) et le deuxième multiplicateur (92d) par l'intermédiaire d'un inverseur (94c), le deuxième multiplicateur (92c) et par le premier multiplicateur (91d),
- des premiers (95a) et deuxièmes mémoires auxiliaires (95b) permettant de mémoriser respectivement les sommes délivrées par les premiers (93a) et deuxièmes (93b) respectivement troisièmes (93c) et quatrièmes (93d) sommateurs, ces sommes mémorisées, correspondant aux coefficients impairs YN/2-2k-1 respectivement pairs Y2k de transformée.

**Patentansprüche**

1. Verfahren zum Codieren eines digitalen Signals (x), das durch digitale Abtastwerte x(n) dargestellt ist, welche Abtastwerte in Blöcken von aufeinanderfolgenden N Abtastwerten umgruppiert sind und dann einer Fensterung unterzogen werden, bei welcher eine räumliche und zeitliche Wichtung der Abtastwerte, eine Funktion der Ordnung n der Abtastwerte, in den Block yn = x(n).h(N-1-n) durchgeführt wird, wobei h(N-1-n) ein bestimmtes Wichtungsgesetz darstellt, welches Verfahren gekennzeichnet ist durch:

- Durchführen einer modifizierten, diskreten Cosinustransformation (TCDM) bei den Abtastwerte-Blöcken, um die geradzahligen Transformationskoeffizienten der Form:

$$Y2k = \sum_{n=0}^{N-1} yn.Cos(2\pi/(4N).(2n+1)(4k+1)+(4k+1)\pi/4)$$

für $k \in [0,...,N/2-1]$ mit YN-k = -Yk-1 zu berechnen, wobei der Phasenverschiebungsterm entsprechend der Ordnung k des vorerwähnten Koeffizienten verteilt ist,
- Ausdrücken der berechneten geradzahligen Koeffizienten Y2k in Form einer komplexen inversiblen Umformung

$$Y2k+N/4+jY2k$$

$$= (-1)^{k+1}.W8^{-1}.\sum_{n=0}^{N/4-1} ((y'n-y''n+N/4)+j(y''n+y'n+N/4))$$

$$.W4N^{(4k+1)(4n+1)}$$

für k=0,..., N/4-1
mit

$$y'n = x2n.h2n$$
$$y''n = xN-2n-1.hN-2n-1$$
$$W4N = Cos(2\pi/4N)-j.sin(2\pi/4N);$$

- Berechnen der komplexen inversiblen Transformation ab dem Hilfsberechnungsausdruck:

$$Zk = (-1)^{k+1}.W8^{-1}.W4N^{4k+1}.\sum_{n=0}^{N/4-1} (zn.WN^n).WN/4^{nk}$$

wobei

$$zn = (y2n-yN/2-1-2n) +j (yN-1-2n+yN/2+2n)$$

für n =0,... ,N/4-1 ist.

2. Verfahren nach Anspruch 1, dadurch **gekennzeichnet**, daß das Berechnen der komplexen inversiblen Transformation durch die nachfolgenden Schritte durchgeführt wird:

a) Berechnen von zn für n=0,...N/4-1;
b) Berechnen von z'n=zn.WN$^n$ für n=0,...,N/4-1;
c) Berechnen mit Hilfe einer inversen Fast Fourier-Transformation (FFT$^{-1}$) der Größe N/4 entsprechender Koeffizienten Z'k:

$$Z'k = FFT^{-1}.z'n;$$

d) Berechnen des Ausdrucks:

$$Zk= ((-1)^{k+1}.W8^{-1} W4N^{4K+1}).Z'k$$

für k=0,... N/4-1;

e) nacheinander Bestimmen der geradzahligen Transformationskoeffizienten

Y2k Im[Zk] imaginärer Teil von Zk
Y2k+N/4 Re[Zk] realer Teil von Zk;

f) stellvertretende Übertragung der digitalen Abtastwertex(n), welche das digitale Signal N der Transformationskoeffizienten Y2, Y2k+N/4 in Form eines codierten Signals darstellen.

3. Verfahren nach Anspruch 2, dadurch **gekennzeichnet**, daß der Hilfsberechnungsausdruck ausgedrückt wird in Form von:

$$Zn = (-1)^{k+1} \cdot W8^{-1} \cdot WN^k \cdot \sum_{n=0}^{N/4-1} (znW4N^{(4n+1)} \cdot WN/4^{nk})$$

die Schritte b) und d) vertauscht werden, wobei die komplexen Multiplikationen mit $W4N^{(4n+1)}$ am Anfang oder am Ende der Berechnung vorgesehen sind.

4. Verfahren zum Decodieren eines digitalen Signals (x), das durch digitale Abtastwerte x(n) dargestellt ist, welche Abtastwerte in Blöcken von N Abtastwerten umgruppiert und gemäß einem der vorhergehenden Ansprüche 1 bis 3 codiert sind, dadurch **gekennzeichnet**, daß das Decodieren darin besteht:

- eine Permutation der realen Teile YN/4 + 2k und des imaginären Teils Y2k der übertragenen Transformationskoeffizienten durchzuführen;
- die permutierten Koeffizienten einem Codierverarbeitungsprozeß durch Berechnen des komplexen Teils der direkten, modifizierten, diskreten Cosinus-Transformation (TDCM) der Form RE[Zk], Im[Zk] zu unterziehen;
- die realen und imaginären Teile des komplexen Teils zu permutieren;
- eine überlappende Berechnung zu bewerkstelligen, um die Abtastwerte x(n) wiederherzustellen.

5. Verfahren nach Anspruch 4, dadurch **gekennzeichnet**, daß der Verarbeitungsprozeß, der mit dem Codierverarbeitungsprozeß durch Berechnen des komplexen Teils der direkten, modifizierten diskreten Cosinustransformation (TCDM) identisch ist, aufweist:

- Berechnen von $z'n = zn.WN^n$ für n = 0,...,N/4-1;
- Berechnen von Z'k durch eine inverse Fast-Fourier-Transformation $(FFT^{-1})$, der Größe N/4

$$z'k = FFT^{-1}.z'n:$$

- Berechnen des Ausdrucks $Zk = ((-1)^{K+1} \cdot W8^{-1}.W4N^{4k+1}) .Z'k$ für k=0,...,N/4-1.

6. Verfahren nach Anspruch 5, dadurch **gekennzeichnet**, daß, da die Gesamtheit der Schritte b), c) und d) eine inversible komplexe Transformation bilden, die Umkehr der Transformation, welche durch die vorerwähnten Schritte gebildet ist, den Kernpunkt einer inversen, modifizierten Cosinustransformation (einer inversen TCDM) darstellt, wobei die inverse TDCM mittels einer entsprechenden direkten TCDM auf folgende Weise berechnet wird:

- Vertauschen der realen und imaginären Teile der Eingangssignale z = a+jb ==> z* = b+ja, um umgekehrte Eingangssignale zu erzeugen;
- Berechnen der direkten TCDM der umgekehrten Eingangssignale, um Ausgangssignale Y*k zu erzeugen, und
- Vertauschen der realen und imaginären Teile der Ausgangssignale Y*k, um inverse Ausgangssignale Yk zu erzeugen.

7. Vorrichtung zum Codieren eines digitalen Signals (x), das durch digitale Abtastwerte x(n) dargestellt ist, die in Blökken von aufeinanderfolgenden N Abtastwerten umgruppiert sind, dadurch **gekennzeichnet**, daß die vorrichtung aufweist:

- einen ersten (111) und einen zweiten Eingangsspeicher (112), um jeweils N/2 aufeinanderfolgende Abtzastwerte zu speichern, wobei der zweite Eingangsspeicher das Speichern der verzögerten Abtastwerte N/2 zuläßt;

- Recheneinheiten (1,2,3,4), um nach einer Fensterung, die darin besteht, eine räumliche Wichtung der Abtastwerte yn = x(n).h(N-1-n) durchzuführen, wobei h(N-1-n) ein bestimmtes Wichtungsgesetz darstellt, an den Abtastwerten eine modifizierte diskrete Cosinustransformation TCDM vorzunehmen, um die geradzahligen Transformationskoeffizienten der Form:

$$Y2k = \sum_{n=0}^{N-1} yn.cos(2\pi/(4N).(2n+1).(4k+1)+(4k+1)\pi/4)$$

für $k \in [0,..., N/2-1]$ mit YN-k = - YK-1 zu berechnen, des berücksichtigen Koeffizienten aufgeteilt wird, die geradzahligen Koeffizienten Y2k von einer komplexen inversiblen Transformation Y2k+N/4+jY2k ab von einem Hilfsberechnungsausdruck ZK erhalten werden:

$$Zk = (-1)^{k+1}.W8^{-1}.W4N^{4k+1}.\sum_{n=0}^{N/4-1} (zn.WN^n).WN/4^{nk}$$

wobei

$$zn = (y2n-yN/2-1-2n) + j (yN-1-2n+yN/2+2n)$$

für n = 0,...,N/4-1 ist.

8. Vorrichtung nach Anspruch 7, dadurch **gekennezeichnet**, daß die Recheneinheiten der inversiblen komplexen Transformation Y2K+N/4+jY2K unmittelbar aufeinanderfolgend aufweisen:

   - erste Einheiten (1) für eine komplexe Berechnung, um die Berechnung von zn durchzuführen;
   - zweite Einheiten (2) für eine komplexe Berechnung von z'n = zn.WN$^n$, für n = 0,...,N/4-1;
   - Einheiten (3) für eine Berechnung durch die inverse Fast-Fourier-Transformierte FFT$^{-1}$.z'n;
   - dritte Einheiten (4) für eine komplexe Berechnung des Ausdrucks

   $$Zk = (-1)^{k+1}.W8^{-1}.W4N^{4k+1}.Z'k \text{ für } k = 0,...,N/4-1$$

   und anschließende Bestimmung der geradzahligen Transformationskoeffizienten

   Y2k Im[Zk] imaginärer Teil von Zk,
   Y2k+N/4 Re[Zk] realer Teil von Zk.

9. Vorrichtung nach einem der Ansprüche 7 oder 8, dadurch **gekennzeichnet**, daß die ersten Einheiten(1) zum komplexen Berechnen von zn, die mit den ersten und zweiten Eingangsspeichern (111, 112) verbunden sind, aufweisen:

   - erste und zweite Summiereinheiten (121, 122), wobei die ersten Summiereinheiten (121) einerseits unmittelbar von dem ersten Eingangsspeicher den Wert des gewichteten Abtastwerts y2n und andererseits von dem zweiten Eingangsspeicher (112) über ein mit -1 multiplizierendes Multiplizierglied (123) den Wert des gewerteten Abtastwerts yN/2-1-2n erhalten, und wobei die zweite Summiereinheit (122) einerseits von dem ersten Eingangsspeicher den gewichteten Abtastwert yN/2+2n und andererseits von dem zweiten Eingangsspeicher den gewichteten Abtastwert yN-1-2n erhalten;
   - erste und zweite Zusatzspeicher von N/4 Stellen, die mit einem Ausgang der ersten und zweiten Addierer verbunden sind und Speichern des realen bzw. imaginären Teile von

   $$zn = (y2n-yN/2-1-2n) +j(yN-1-2n+yN/2+2n)$$

   zulassen.

10. Vorrichtung nach einem der Ansprüche 7 bis 9, dadurch **gekennzeichnet**, daß die zweiten Einheiten (2) für eine komplexe Multiplikation zum Berechnen von z'n aufweisen:

   - erste Festwertspeicher (20a, 20b) für

   $$WN^n = cos2\pi n/N + j.sin2\pi n/N;$$

   - erste Multiplikationseinheiten (21a, 22a), die einerseits den realen Teil von zn = a+jb und andererseits den

realen Teil $\cos2\pi n/N$ bzw. den imaginären Teil $\sin2\pi n/N$ von $WN^n$ erhalten und die Produkte $a.\cos2\pi n/N$ und $a\sin2\pi n/N$ abgeben;

- zweite Multiplikationseinheiten, die einerseits den imaginären Teil b von $zn = a+jb$ und andererseits den realen Teil $\cos2\pi n/N$ bzw. den imaginären Teil $\sin2\pi n/N$ von $W/n$ erhalten und die Produkte $b.\cos2\pi n/N$ und $b.\sin2\pi n/N$ abgeben;

- erste Summiereinheiten (23), die einerseits von der ersten Multipliziereinheit (21a) das Produkt $a.\cos2\pi n/N$ und andererseits von der zweiten Multipliziereinheit (22b) das Produkt $b.\sin2\pi n/N$ über eine mit -1 multiplizierende Multipliziereinheit (23a) erhalten und den realen Teil von $z'n = a'+jb'$ abgeben, nämlich

$$a' = a.\cos2\pi n/N - b.\sin2\pi n/N;$$

- zweite Summiereinheiten (24), die einerseits von der ersten Multipliziereinheit (22a) das Produkt $a.\sin2\pi n/N$ und andererseits von der zweiten Multipliziereinheit (21b) das Produkt $b.\cos2\pi n/N$ erhalten und den imaginären Teil von $z'n=a'+jb'$ abgeben, nämlich $b'=a.\sin2\pi n/N + b.\cos2\pi n/N$;

- erste und zweite zusatzspeicher (25, 26), um die Werte des realen Teils a' bzw. des imaginären Teils b' von z'n zu speichern.

11. Vorrichtung nach einem der Ansprüche 7 bis 10, dadurch **gekennzeichnet** daß die dritten Einheiten (4) für eine komplexe Berechnung von Z'k aufweisen:

- Speicher (40a, 40b) der Konstanten $W8^{-1}$, $W4N^{4-k+1}$ entsprechend deren realen und imaginären Teil;

- erste Multipliziereinheiten (41a, 42a), die einerseits den realen Teil des Ausdrucks Z'k und andererseits den realen bzw. imaginären Teil der Konstanten $W8^{-1}$, $W4N^{4k+1}$ der Speicher (40a, 40b) erhalten und die entsprechenden Produkte abgeben;

- zweite Multipliziereinheiten (41b, 42b), die einerseits den imaginären Teil des Ausdrucks Z'k und andererseits den realen bzw. imaginären Teil der Konstanten $W8^{-1}$, $W4N^{4k+1}$ der Speicher (40a, 40b) erhalten und die entspechenden Produkte abgeben;

- erste Summiereinheiten (43), die einerseits das Produkt von der ersten Multipliziereinheit(41a) und das Produkt von der zweiten Multipliziereinheit (42b) über eine mit -1 multiplizierende Multipliziereinheit (43a) erhalten und den realen Teil des Ausdrucks Zk abgeben, nämlich

$$RE[Zk] = YN/4+2k;$$

- zweite Summiereinheiten (44), die einerseits das Produkt von der ersten Multipliziereinheit (42a) und andererseits des Produkt von der zweiten Multipliziereinheit (41b) erhalten und den imaginären Teil des Ausdrucks Zk abgeben, nämlich $im[Zk]=Y2k$.

12. Vorrichtung zum Decodieren eines digitalen Signals (x), das durch digitale Abtastwerte x(n) dargestellt ist, die in Blöcken von aufeinanderfolgenden N Abtastwerten umgruppiert sind, wobei diese Abtastwerte mittels der Codiervorrichtung gemäß einem der Ansprüche 7 bis 11 codiert worden sind, dadurch **gekennzeichnet**, daß die Decodiervorrichtung aufweist:

- Einrichtungen (5) zum Speichern und Lesen der übertragenen Transformationskoeffizienten
$$YN/4+2k = Re[Zk] \text{ und } Y2k = Im[Zk],$$
wobei die Leseeinrichtungen eine Permutation der übertragenen, gespeicherten Transformationskoeffizienten zulassen,

- Einrichtungen (6) zum Berechnen des komplexen Teils der direkten TCDM, welche nacheinander komplexe Multipliziereinrichtungen (62) für die Berechnung von z'n, Berechnungseinrichtungen (63) für die inverse Fast-Fourier-Transformierte $FFT^{-1}.z'n$ und Einrichtungen (64) zum Berechnen des Ausdrucks

$$Zk = (-1)^{k+1}.W8^{-1}.W4N^{4k+1}.Z'k$$

aufweisen.

13. Vorrichtung nach Anspruch 12, dadurch **gekennzeichnet**, daß die Einrichtungen (6) zum Berechnen des komplexen Teils der direkten TCDM Module (62, 63 bzw. 64) aufweisen, die den Modulen (2,3 und 4) der Codiervorrichtung entsprechen.

14. Vorrichtung zum Codieren bzw. Decodieren eines digitalen Signals (x), das durch Abtastwerte x(n) dargestellt ist, die in Blöcken von aufeinanderfolgenden N Abtastwerten umgruppiert sind, dadurch **gekennzeichnet,** daß die Vorrichtung aufweist:

- erste Einrichtungen (8) zum Berechnen durch komplexes Multiplizieren eines Ausdrucks

$$z'n = ( (x2n.c - xN/2-1-2n.s)$$

$$+ j.zo^{-N/2}.(x2n.s + xN/2-2n-1.c)) .(c+js)$$

von geradzahligen Abtastwerten x2n bzw. ungeradzahligen Abtastwerten xN/2-1-2n, wobei gilt:

$$c= \cos 2\pi \, \frac{4n+1}{4N} \text{ und } s= \sin 2\pi \, \frac{4n+1}{4N}$$

- Einrichtungen (3) zum verarbeitendurch eine inverse Fast-Fourier-Transformation FFT$^{-1}$ des Ausdrucks z'n um die Ausdrücke zu erhalten:

$$Z' (N/8-k) = FFT^{-1}.z'n;$$

- zweite Recheneinrichtungen (9), zum komplexen Multiplizieren der geradzahligen Koeffizienten Y2k bzw. der ungeradzahligen Koeffizienten YN/2-2K-1 der Transformation.

**15.** Vorrichtung nach Anspruch 14, dadurch **gekennzeichnet**, daß die ersten Recheneinrichtungen für eine komplexe Multiplikation aufweisen:

- einen ersten (81a) und einen zweiten Eingangsspeicher (81b) um die ungeradzahligen Abtastwerte xN/2-1-2n bzw. die geradzahligen Abtastwerte x2N zu speichern;
- einen ersten (80a) und einen zweiten Festpeicher (80b) zum Speichern der vorerwähnten Werte c und s,
- erste Multipliziereinrichtungen (82a, 82b), die einerseits die geraden Abtastwerte x2n bzw. die ungeraden Abtastwerte xN/2-1-2n und andererseits den Wert c über eine mit -1 multiplizierende Multipliziereinheit bzw. direkt erhalten,
- zweite Multipliziereinheiten (83a, 83b), welche die geraden bzw. ungeraden Abtastwerte, den Wert der Konstanten s direkt bzw. über eine mit -1 multiplizierende Multipliziereinheit (89), andererseits von dem Speicher (80b) erhalten,
- erste Summiereinheiten (84a, 84b), welche das Produkt von der ersten (82a) und der zweiten Multipliziereinheit (83a) bzw. von der ersten (82b) und der zweiten Multipliziereinheit (82b) erhalten,
- zweite Summiereinheiten (86, 86b), die einerseits direkt die von den ersten summiereinheiten (84a) gelieferte summe und andererseits über eine verzögerungsleitung (85a) und von einem Inverter (861i) bzw. direkt oder über eine verzögerungsleitung (85a), die von der ersten Summiereinheit (84b) gelieferte Summe erhalten,
- dritte Summiereinheiten (87a), die einerseits die ungeraden Abtastwerte über einen Inverter (871i) und andererseits die von den zweiten Summiereinheiten (86a) gelieferte Summe bzw. einerseits die geraden Abtastwerte und andererseits die von der zweiten Summiereinheit (86b) gelieferte summe erhalten, wobei die dritten Summiereinheiten (87a, 87b) den realen bzw. imaginären Teil von z'n liefern,
- erste und zweite Speicher des Typs RAM (88a, 88b), welche den realen bzw. imaginären Teil von z'n erhalten.

**16.** Vorrichtung nach Anspruch 14, dadurch **gekennzeichnet**, daß die zweiten Recheneinheiten (6) zum komplexen Multiplizieren der geradzahligen und der ungeradzahligen Transformationskoeffizienten Y2k bzw. YN/2-2k-1 aufweisen:

- erste und zweite Featwertspeicher (90a, 90b) von Werten c und s,
- erste Multipliziereinheiten (91a bis 91d), die in der nachstehend wiedergegebenen Reihenfolge den realen Teil Re[Z'N/8-k], den imaginären Teil Im [Z'N/8+k], den realen Teil Re[Z'N/8+k], den imaginären Teil Im [Z'N/8+k] der inversen Fast-Fourier-Transformation von z'n, FFT$^{-1}$.z'n, erhalten, wobei die ersten Multipliziereinheiten von dem ersten Speicher (90a) den Wert c erhalten,
- zweite Multipliziereinheiten (92a bis 92d), die in der nachstehend wiedergegebenen Reihenfolge den realen Teil Re[Z'N/8-k], den imaginären Teil Im[Z'N/8-k], den realen Teil Re[Z'N/8+k], und den imaginären Teil Im [Z'N/8-k] der inversen Fast-Fourier-Transformation von z'n, FFT$^{-1}$.z'n, erhalten, wobei die zweiten Multipliziereinheiten von dem zweiten Speicher (90b) den Wert s erhalten,
- erste (93a), zweite (93b), dritte (93c) und vierte Summiereinheiten (93d), welche die Produkte von der ersten Multipliziereinheit (91a) und der zweiten Multipliziereinheit (92a), von der zweiten Multipliziereinheit (92a) über einen Inververter (93b) und über die erste Multipliziereinheit (91b), von der ersten Multipliziereinheit (91c) und der zweiten Multipliziereinheit (92d) über einen Inverter (94c), von der zweiten Multipliziereinheit (92c) und über die erste Multipliziereinheit (91d) erhalten,
- erste (95a) und zweite Zusatzspeicher (95b) zum Speichern der Summen von den ersten (93a) und den zweiten (93b) bzw. von den dritten (93c) und vierten (93d) Summiereinheiten, wobei die gespeicherten Summen den ungeraden und geraden Transformationsquotienten YN/2-2k-1 bzw. Y2k entsprechen.

**Claims**

1. A method of encoding a digital signal (x) represented by digital samples x(n), said samples being lumped into blocks of N successive samples, and thus submitted to a windowing operation consisting in space or time weighting of the samples as a function of the position n of each sample within the block such that yn = x(n).h(N-1-n) where h(N-1-n) represents a determined weighting law, said method being characterized by :

   - performing a modified discrete cosine transform on the blocks of samples to calculate the even order transformation coefficients of the form:

   $$Y2k = \sum_{n=0}^{N-1} yn.\cos(2n/(4N).(2n+1).(4k+1)+(4k+1).\pi/4)$$

   for k ∈ [0, ..., N/2-1] with YN-k = -Yk-1
   the phase shift term being distributed as a function of the order k of the above-mentioned coefficient;
   - expressing said calculated even order coefficients Y2k in the form of an invertible complex transformation

   $$Y2k+N/4+jY2k =$$

   $$(-1)^{k+1}.W8^{-1}.\sum_{n=0}^{N/4-1}((y'n-y''n+N/4)+j(y''n+y'n+N/4)).W4N^{(4k+1)(4n+1)}$$

   for k = 0, ..., N/4-1 with
   $$y'n = x2n.h2n$$
   $$y''n = xN-2n-1.hN-2n-1$$
   $$W4N = \cos(2\pi/4N)+j.\sin(2\pi/4N); \text{ and}$$
   - calculating said invertible complex transformation on the basis of the following auxiliary calculation equation:

   $$zk = (-1)^{k+1}.W8^{-1}.W4N^{4k+1}.\sum_{n=0}^{N/4-1}(zn.WN^n).WN/4^{nk}$$

   where:
   $$zn = (y2n-yN/2-1-2n) + j(yN-1-2n+yN+2+2n)$$
   for n = 0, ..., N/4-1.

2. The method according to claim 1, characterized in that said invertible complex transform is calculated by the following successive steps:

   a) calculating zn for n = 0,..., N/4-1;
   b) calculating z'n = zn.WN^n for n = 0,..., N/4-1;
   c) calculating the corresponding coefficients Z'k by the inverse fast Fourier transform FFT$^{-1}$ of size N/4:

   $$Z'k = FFT^{-1}.z'n;$$

   d) calculating the equation

   $$Zk = ((-1)^{k+1}.W8^{-1}.W4N^{4k+1}).Z,k$$

   for k = 0,..., N/4-1;
   e) successively determining the even order transformation coefficients
   Y2k Im[Zk] imaginary portion of Zk
   Y2k+N/4 Re[Zk] real portion of Zk;
   f) transmitting said transformation coefficients Y2k, Y2k+N/4 in the form of a coded signal instead of the digital sample x(n) constituting the digital signals.

3. The method according to claim 2, characterized in that with the auxiliary calculation equation being expressed in the form:

$$Zk = (-1)^{k+1}.W8^{-1}.WNk . \sum_{n=0}^{N/4-1} (zn.w4N^{(4n+1)}.WN/4^{nk})$$

steps b) and d) are interchanged, with complex multiplications by $W4N^{(4n+1)}$ being placed at the beginning or the end of the calculation.

4. A method of decoding a digital signal (x) represented by digital samples x(n), said samples being lumped into blocks of N samples, and being encoded according to claim 1, the decoding being characterized in that it consists in:

- permutating the real and imaginary portions YN/4 + 2k, Y2k of the transmitted transformation coefficients;
- subjecting said permutated coefficients to an encoding process by calculating the complex portion of the forward MDCT, of the form Re[Zk], Im[Zk];
- permutating the real and imaginary portions of said complex portion; and
- performing an overlap calculation to reconstruct said samples x(n).

5. The method according to claim 4, characterized in that said process identical to the encoding process by calculating said forward MDCT complex portion comprises:
  calculating

$$z'n = zn.WN^n$$

for n = 0,..., N/4-1;
  calculating Z'k by the inverse fast Fourier transform $FFT^{-1}$ of size N/4

$$Z'k = FFT^{-1}.z'n;$$

and
  calculating the expression

$$Zk = ((-1)^{k+1}.W8^{-1}.W4N^{4k+1}).Z'k$$

  for k = 0 ..., N/4-1.

6. The method according to claim 5, characterized in that with the set of steps b), c), and d) forming an invertible complex transformation, the inverse of the transform constituted by the above steps constitutes the core of an inverse modified discrete cosine transform (inverse MDCT), which inverse MDCT is calculated by means of a corresponding forward MDCT following:

- interchanging the real and imaginary portions of the input signals, z = a+jb ==> z* = b+ja to generate inverted input signals;
- calculating the forward MDCT of the inverted input signals to generate output signals Y*k; and
- interchanging the real and imaginary portions of the output signals Y*k to generate inverted output signals Yk.

7. Apparatus for encoding a digital signal (x) represented by digital samples x(n) lumped into blocks of N successive samples, the apparatus being characterized in that it includes:

- first (111) and second (112) input memories each serving to store N/2 successive samples, said second input memory enabling said samples to be stored with a delay of N/2; and
- calculation means (1,2,3,4) following a windowing operation on said samples which consists in performing space weighting of the samples yn = x(n).h(N-1-n) where h(N-1-n) represents a determined weighting law, with a modified discrete cosine transform MDCT so as to calculate the even order transform coefficients of the form:

$$Y2k = \sum_{n=0}^{N-1} yn.cos(2\pi/(4N).(2n+1).(4k+1)+(4k+1).\pi/4)$$

  for k $\in$ [0, ..., N/2-1]
  with YN-k = -Yk-1
the phase shift term being distributed as a function of the order k of the coefficient under consideration,
  the even order coefficients Y2k being obtained from an invertible complex transform Y2k+N/4+jY2k using an auxiliary calculation equation:

$$Zk = (-1)^{k+1}.W8^{-1}.W4N^{4k+1}.\sum_{n=0}^{N/4-1}(zn.WN^n).WN/4^{nk}$$

where:

$$zn = (y2n-yN/2-1-2n) + j(yN-1-2n+yN/2+2n)$$

for n = 0, ..., N/4-1.

8. Apparatus according to claim 7, characterized in that said means for calculating the invertible complex transformation Y2K+N/4+jY2k comprise successively and in cascade:

- first complex calculation means (1) enabling zn to be calculated;
- second complex calculation means (2) for calculating

$$z'n = zn.WN^n$$

for n = 0, ..., N/4-1;
- inverse fast Fourier transform calculation means (3) to calculate $FFT^{-1}.z'n$; and
- third complex calculation means (4) for calculating the expression:

$$Zk = (-1)^{k+1}.W8^{-1}.W4N^{4k+1}.Z'k$$

for k = 0, ..., N/4-1
and for successively determining even order transformation coefficients:

Y2k Im[zk] imaginary portion of Zk
Y2k+N/4 Re[Zk] real portion of Zk.

9. Apparatus according to one of claims 7 or 8, characterized in that said first complex calculation means (1) for calculating zn comprise, connected to said first (111) and second (112) input memories:

- first (121) and second (122) summing means, said first summing means (121) receiving firstly directly from said first input memory the weighted sample value y2n, and secondly from said second input memory via a multiplier (123) by -1, the weighted sample value yN/2-1-2n, said second summing means (122) receiving firstly from said first input memory the weighted sample yN/2+2n, and secondly from said second input memory the weighted sample yN-1-2n; and
- first and second auxiliary memories of capacity N/4 connected respectively to the outputs of the first and second adders and serving to store the real portion and the imaginary portion respectively of
$$zn = (y2n-yN/2-1-2n) + j(yN-1-2n+yN/2+2n)$$

10. Apparatus according to one of claims 7 to 9, characterized in that said second complex multiplication means for calculating Z'n comprise:

- memory means (20a, 20b) for storing the constants

$$WN^n = \cos(2\pi n/N) + j.\sin(2\pi n/N)$$

- first multiplier means (21a, 22a) receiving firstly the real portion a of $zn = a+jb$ and secondly the real portion $\cos(2\pi n/N)$ or the imaginary portion $\sin(2\pi n/N)$ of $WN^n$, and delivering the products $a.\cos(2\pi n/N)$ and $a.\sin(2\pi n/N)$;
- second multiplier means receiving firstly the imaginary portion b of $zn = a+jb$ and secondly the real portion $\cos(2\pi n/N)$ or the imaginary portion $\sin(2\pi n/N)$ of $WN^n$, and delivering the products $b.\cos(2\pi n/N)$ and $b.\sin(2\pi n/N)$;
- first summing means (23) receiving firstly from the first multiplier means (21a) the product $a.\cos(2\pi n/N)$ and secondly from the second multiplier means (22b) the product $b.\sin(2\pi n/N)$ via a multiplier by -1, to deliver the real portion of $z'n = a'+jb'$,
$$a' = a.\cos(2\pi n/N) - b.\sin(2\pi n/N);$$
- second summing means (24) receiving firstly from the first multiplier means (22a) the product $a.\sin(2\pi n/N)$ and secondly from the second multiplier means (21b) the product $b.\cos(2\pi n/N)$ and delivering the imaginary portion of $z'n=a'+jb'$
$$b' = a.\sin(2\pi n/N) + b.\cos(2\pi n/N); \text{ and}$$
- first and second auxiliary memories (25, 26) for storing the values of the real and imaginary portions a' and b' respectively of z'n.

11. Apparatus according to one of claims 7 to 10, characterized in that said third calculation means (4) for performing complex multiplication on Z'k comprise:

- means (40a, 40b) for storing the real and imaginary portions of the constants $W8^{-1}$ and $W4N^{4k+1}$;
- first multiplier means (41a, 42a) receiving firstly the real portion of the expression Z'k and secondly the real portion or the imaginary portion of said constants $W8^{-1}$, $W4N^{4k+1}$ from the memory means (40a, 40b), and delivering the corresponding products;
- second multiplier means (41b, 42b) receiving firstly the imaginary portion of the expression Z'k and secondly the real portion or the imaginary portion of said constants $W8^{-1}$ and $W4N^{4k+1}$ from the memory means (40a, 40b), and delivering the corresponding products;
- first summing means (43) receiving firstly the product delivered by the first multiplier means (41a) and secondly the product delivered by the said second multiplier means (42b) via a multiplier by -1 (43a), and delivering the real portion of the expression for Zk such that:

$$Re[Zk] = YN/4+2k;\ and$$

- second summing means (44) receiving firstly the product delivered by the first multiplier means (42a) and secondly the product delivered by the second multiplier means (41b), and delivering the imaginary portion of the expression Zk, such that:

$$Im[Zk] = Y2k.$$

12. Apparatus for decoding a digital signal (x) represented by digital samples x(n) lumped into blocks of N successive samples, said samples being encoded by means of the encoding apparatus according to one of claims 7 to 11, the decoding apparatus being characterized in that it includes:

- means (5) for storing and reading the transmitted transformation coefficients
$$YN/4+2k = Re[Zk]\ and\ Y2k = Im[Zk],$$
said real means enabling said stored transmitted transformation coefficients to be permutated; and
- means (6) for calculating the complex portion of the forward MDCT comprising successively and in cascade complex multiplication means (62) for calculating z'n, means (63) for calculating the inverse fast Fourier transform $FFT^{-1}.z'n$, and means (64) for calculating the expression

$$Zk = (-1)^{k+1}.W8^{-1}.W4N^{4k+1}.Z'k.$$

13. Apparatus according to claim 12, characterized in that said means (6) for calculating the complex portion of the forward MDCT comprise modules (62, 63, 64) that are identical to respective modules (2, 3, 4) of the encoder apparatus.

14. Apparatus for encoding and decoding a digital signal (x) represented by samples x(n) lumped into blocks of N successive samples, the apparatus being characterized in that it comprises:

- first means (8) for calculating by complex multiplication an equation

$$z'n = ((x2n.c - xN/2-1-2n.s)$$

$$+ j.zo^{-N/2}.(x2n.s + xN/2-2n-1.c)).(c+js)$$

on the basis of even samples x2n and odd samples xN/2-1-2n where:

$$c = Cos\ 2\pi\ \frac{4n+1}{4N}\ and\ s = \sin 2\pi\ \frac{4n+1}{4N}$$

- means (3) for applying the inverse fast Fourier transform $FFT^{-1}$ to the expression z'n to deliver the expressions

$$Z'(N/8-k) = FFT^{-1}.z'n;\ and$$

- second calculation means (9) for performing complex multiplication to calculate the even coefficients Y2k and the odd coefficients YN/2-2K-1 of the transform.

15. Apparatus according to claim 14, characterized in that said first means (8) for calculation by complex multiplication comprise:

- first (81a) and second (81b) input memories for storing odd and even samples xN/2-1-2n and x2N respectively;
- first (80a) and second (80b) permanent memories for storing the above-mentioned values of c and s;
- first multiplier means (82a, 82b) receiving firstly the even samples x2n or the odd samples xN/2-1-2n and secondly the value c via a multiplier by -1 or directly;
- second multiplier means (83a, 83b) receiving firstly the even samples or the odd samples, and secondly, from the memory (80b), the value of the constant s either directly or via a multiplier by -1 (89);
- first summing means (84a, 84b) receiving the products delivered by respective ones of said first (82a, 82b) and second (83a, 83b) multipliers;
- second summing means (86a, 86b) receiving firstly directly the sums delivered by the first summing means (84a) and secondly the sums delivered thereby via respective delay lines (85b) with and without an inverter (861i) ;
- third summing means (87a, 87b) receiving firstly the odd samples via an inverter (871i) or the even samples directly and secondly the sums delivered by respective ones of the second summing means (86a), said third summing means (87a, 87b) delivering the real and imaginary portions respectively of z'n; and
- first and second RAM type memories (88a, 88b) respectively receiving said real and imaginary portions of z'n.

16. Apparatus according to claim 14, characterized in that said second calculation means (9) using complex multiplication to obtain the even coefficient Y2k and the odd coefficients YN/2-2k-1 of the transform comprise:

- first and second permanent memories (90a, 90b) for storing the values of c and s;
- first multipliers (91a, 91b, 91c, 91d) receiving in order: the real portion Re[Z'N/8-k], the imaginary portion Im[Z'N/8-k], the real portion Re[Z'N/8+k], and the imaginary portion Im[Z'N/8+k] of the inverse fast Fourier transform of z'n, $FFT^{-1}$.z'n, said first multiplier means also receiving the value of c from the first memory (90a);
- second multiplier means (92a, 92b, 92c, 92d) receiving in order: the real portion Re[Z'N/8-k], the imaginary portion Im[Z'N/8-k], the real portion Re[Z'N/8+k], and the imaginary portion Im[Z'N/8+k] of the inverse fast Fourier transform of z'n, $FFT^{-1}$.z'n, said second multiplier means also receiving the value s from the second memory (90b);
- first (93a), second (93b), third (93c), and fourth (93d) summing means respectively receiving products from the first (91a) and second multipliers (92b) as follows: directly from the first multiplier and from the second multiplier; from the second multiplier (92b) via an inverter (93b) and directly from the first multiplier (91b); directly from the first multiplier and from the second multiplier via an inverter (94c); and directly from the second multiplier (92c) and from the first multiplier (91d); and
- first (95a) and second (95b) auxiliary memories respectively storing the sums delivered by the first (93a) and second (93b) or by the third (93c) and fourth (93d) summing circuits, said stored sums corresponding to the odd coefficient YN/2-2k-1 and to the even coefficients Y2k of the transform, respectively.

# FIG. 1

ENTREE
échantillons x(n)
blocs N échantillons — A

FENETRAGE

$y(n)=x(n).h(N-1-n)$ — B

TCDM

$$Y2k=\sum_{n=0}^{N-1} yn.\cos\left(2\pi/(4N).(2n+1)(4k+1)+(4k+1)\pi/4\right)$$ — C

TRANSFORMATION COMPLEXE INVERSIBLE

$$Y2k+N/4+jY2k=$$

$$(-1)^{k+1}.W8^{-1}\sum_{n=0}^{N/4-1}\left((y'n-y''n+N/4)+j(y''n+y'n+N/4)\right).W4N^{(4k+1)(4n+1)}$$ — D

$$Zk=(-1)^{k+1}.W8^{-1}.W4N^{4k+1}\sum_{n=0}^{N/4-1}(zn.WN^n).WN/4^{nk}$$ — E

$$\text{avec } zn=(y2n-yN/2-1-2n)+j(yN-1-2n+yN/2+2n)$$

# FIG.2

$$zn = y2n - yN/2-1-2n \\ + j(yN-1-2n + yN/2+2n)$$  a

$$z'n = zn \cdot WN^n \\ WN = \cos(2\pi n/N) + j\sin(2\pi n/N)$$  b

$$Z'k = FFT^{-1} z'n$$  c

$$Zk = (-1)^{k+1} \cdot W8^{-1} \cdot W4N^{4k+1} Z'k$$  d

COEFFICIENTS D'ORDRE PAIR
$$Y2k \in \mathrm{Im}\,[Zk]$$
$$Y2k+N/4 \in \mathrm{Re}\,[Zk]$$  e

TRANSMISSION DES COEFFICIENTS
DE TRANSFORMATION  f

# *FIG. 3*

```
┌─────────────────────────────┐
│          RECEPTION          │
│  PARTIES REELLE YN/4+2k     │ ⌇~ A'
│  PARTIES IMAGINAIRES Y2k    │
└─────────────────────────────┘
              │
              ▼
┌─────────────────────────────┐
│         PERMUTATION         │
│   PARTIES REELLES Y2k       │ ⌇~ B'
│  PARTIES IMAGINAIRES YN/4+2k│
└─────────────────────────────┘
              │
              ▼
┌─────────────────────────────┐
│         CALCUL z'n          │ ⌇~ C'
└─────────────────────────────┘
              │
              ▼
┌─────────────────────────────┐
│          FFT⁻¹              │ ⌇~ D'
└─────────────────────────────┘
              │
              ▼
┌─────────────────────────────┐
│        CALCUL de Zk         │ ⌇~ E'
│  A=Re [Zk]   B=Im [Zk]      │
└─────────────────────────────┘
              │
              ▼
┌─────────────────────────────┐
│         PERMUTATION         │ ⌇~ F'
│   A=Im [Zk]    B=Re [Zk]    │
└─────────────────────────────┘
              │
              ▼
┌─────────────────────────────┐
│  CALCUL DE RECOUVREMENT     │ ⌇~ G'
│        DES BLOCS            │
└─────────────────────────────┘
              │
              ▼
            x(n)
```

TCDM directe $\Big\{$ (C', D', E')

FIG.4

EP 0 511 095 B1

33

FIG.5a

CIRCUIT DE CALCUL DE LA PARTIE COMPLEXE DE LA TCDM DIRECTE (BLOCS 2, 3 et 4)

MODULE CALCUL DE RECOUVREMENT

7

Re{Zn}

Im{Zn}

64 — CALCUL DE Zn

64a — MEMOIRES PERMANENTES

63 — FFT$^{-1}$(N/4)

62 — CALCUL DE Z'k

62a — MEMOIRES PERMANENTES

6

Re{..}

Im{..}

PARTIES REELLES
Re{Zk} = YN/4+2k

PARTIES IMAGINAIRES
Im{Zk} = Y2k

5

sorties du calcul de la TCDM directe

## FIG.5b

EP 0 511 095 B1

FIG.6

36